# EUROPEAN PATENT APPLICATION

(11) **EP 4 535 434 A1**
(43) Date of publication of application: **09.04.2025**
(21) Application number: 23815235.9
(22) Date of filing: 31.05.2023
(51) Int. Cl.: H01L 31/18, H01L 31/0224, H01L 31/054

(54) **PREPARATION METHOD FOR GRID LINE, PREPARATION METHOD FOR CELL SHEET, AND PHOTOVOLTAIC CELL**

(30) Priority: 02.06.2022 CN 202210624197; 02.06.2022 CN 202221378822 U
(71) Applicant: Suzhou Sunwell New Energy Co., Ltd., Suzhou, Jiangsu 215127 (CN)
(72) Inventor: YAO, Yu, Suzhou, Jiangsu 215127 (CN); LI, Zhongtian, Suzhou, Jiangsu 215127 (CN)
(74) Representative: Pfrang, Tilman
(86) International application number: PCT/CN2023/097324
(87) International publication number: WO 2023/232057

(57) **Abstract**

Disclosed in the present invention are a preparation method for a grid line, a preparation method for a cell sheet, and a photovoltaic cell. The preparation method for a grid line comprises the following steps: coating the front face and/or back face of a cell sheet with a mask material, such that the mask material is cured to form a mask; exposing a local area of the mask according to the properties of the mask, so as to form a development reaction area with a width gradient on the mask; and developing the mask in the development reaction area, so as to form a mask opening with a width gradient in the development reaction area; electroplating metal in the mask opening, so as to form a grid line with a width gradient; and removing the mask. By means of the preparation method for a grid line in the embodiments of the present invention, a grid line with a width gradient can be formed on a cell sheet, and after the grid line with a width gradient is packaged into a photovoltaic assembly, the power generation efficiency can be improved.

## Description

### TECHNICAL FIELD

The present disclosure relates to the field of photovoltaic cell manufacturing, and in particular, to a preparation method for a grid line, a preparation method for a photovoltaic cell, and a photovoltaic cell.

### BACKGROUND

In a process of preparing a grid line of a photovoltaic cell by printing silver paste via silk-screen, the silver paste is transferred onto a substrate after passing through the openings prefabricated in the screen to form an unsolidified grid line; when the screen is separated from the substrate, the unsolidified grid line in contact with a yarn of the screen is lifted; and after the screen is separated from the substrate, since the unsolidified grid line has certain leveling property, a vertical section of a finally formed grid line is in a shape similar to a semi-circular arc with a wide lower part and a narrow upper part, and the formed grid line is called a circular arc-shaped grid line. After assembled in a photovoltaic module, the circular arc-shaped grid line has a function of reflecting incident light at multiple angles, and the reflected light has a certain probability of being reflected back to a surface of a solar cell precursor from a material interface of the photovoltaic module, thereby increasing power generation efficiency (photoelectric conversion efficiency), which is called a reflection increasing effect.

In order to further reduce cost of the photovoltaic cell and improve efficiency of the cell, using copper electroplating instead of silver paste printing to prepare the grid line of the photovoltaic cell gets more and more attention and research. When the copper electroplating process is adopted to replace the silver paste printing process to prepare the grid line, a mask opening for electroplating copper is usually rectangular or approximately rectangular, such that the vertical section of the formed grid line is rectangular or approximately rectangular, and the grid line is called rectangular grid line. However, the rectangular grid line cannot increase reflection from the surface of the grid line in multi-directions, and therefore, there is an assembling loss more than that of the circular arc-shaped grid line after assembled in the photovoltaic module, thus affecting the power generation efficiency and the power generation amount in a life cycle. The reflection increasing effect of the circular arc-shaped grid line is characterized by an optical width of the grid line which is usually 70% of a width of a physically widest part of the grid line; the optical width of the rectangular grid line is typically more than 90% of the width of the physically widest part thereof.

Therefore, the present disclosure provides a preparation method for a grid line, a preparation method for a photovoltaic cell, and a photovoltaic cell, which reduce the optical width of the grid line to improve the photoelectric conversion efficiency of the photovoltaic cell.

The disclosure of the above background is only used for assisting understanding of the concept and technical solutions of the present application, and it does not necessarily belong to the conventional art of the present application; the above background should not be used to evaluate the novelty and inventiveness of the present application in the event that there is no clear evidence that the above disclosure is made prior to the filing date of the present application.

### SUMMARY

An object of the present disclosure is to provide a preparation method for a grid line, which reduces an optical width of the grid line to improve the photoelectric conversion efficiency of a photovoltaic cell.

To achieve the above object, an embodiment of the present disclosure provides a preparation method for a grid line, including:
S1 - coating a mask material over a front surface and/or back surface of a solar cell precursor, and curing the mask material to form a mask;
S2 - exposing a local area of the mask according to properties of the mask, to form a development reaction area with width gradient in the mask;
S3 - developing the mask in the development reaction area, to form a mask opening with width gradient in the development reaction area;
S4 - electroplating a metal in the mask opening, to form the grid line with width gradient; and
S5 - removing the mask.

In some embodiments, the preparation method for a grid line further includes:
step S6 - covering a surface of the grid line with a reflecting layer or an alloy welding layer with a melting point lower than 300°C or an organic protective layer;
wherein the step S6 is after the step S4 and before the step S5, or the step S6 is after the step S5.

In some embodiments, wherein the two surfaces of the solar cell precursor are coated with the mask material, and at least a light receiving surface of the solar cell precursor is provided with the grid line with width gradient; when the solar cell precursor has a double-sided power generation structure, the two surfaces of the solar cell precursor are provided with grid lines with width gradient.

**In** some embodiments, the aforementioned step S2 includes: exposing an area of the mask not required to be provided with the opening, such that a curing degree of the mask is gradually increased from the surface of the solar cell precursor in a direction away from the surface of the solar cell precursor, so as to form the development reaction area with width gradient in the mask; or exposing an area of the mask required to be provided with the opening, such that a curing degree of the mask is gradually reduced from the surface of the solar cell precursor in a direction away from the surface of the solar cell precursor, so as to form the development reaction area with width gradient in the mask. The step S3 includes: according to the situation that the curing degree of the mask is gradually increased or gradually reduced from the surface of the solar cell precursor in the direction away from the surface of the solar cell precursor, selecting a corresponding developer for a development reaction with the mask in the development reaction area with width gradient, so as to form the mask opening with width gradient.

In some embodiments, the preparation method for a grid line includes the following steps:
S11 - forming multiple layers of masks on the surface of the solar cell precursor by coating, the multiple layers of masks having different photosensibilities; and
S21 - exposing areas in the multiple layers of masks not required to be provided with openings, such that curing degrees of the multiple layers of masks are increased layer by layer from the surface of the solar cell precursor in a direction away from the surface of the solar cell precursor, so as to form the development reaction area with width gradient in the masks; or exposing areas in the multiple layers of masks required to be provided with openings, such that curing degrees of the multiple layers of masks are reduced layer by layer from the surface of the solar cell precursor in a direction away from the surface of the solar cell precursor, so as to form the development reaction area with width gradient in the masks;
a concentration of a photosensitive component and/or a photosensitive ingredient is adjusted to form the multiple layers of masks having different photosensibilities;
   or
S12 - forming multiple layers of masks on the surface of the solar cell precursor by coating, the multiple layers of masks having different absorption peak values; and
S22 - exposing areas in the multiple layers of masks not required to be provided with openings, such that curing degrees of the multiple layers of masks are increased layer by layer from the surface of the solar cell precursor in a direction away from the surface of the solar cell precursor, so as to form the development reaction area with width gradient in the masks; or exposing areas in the multiple layers of masks required to be provided with openings, such that curing degrees of the multiple layers of masks are reduced layer by layer from the surface of the solar cell precursor in a direction away from the surface of the solar cell precursor, so as to form the development reaction area with width gradient in the masks;
   or
S13 - forming a single layer of mask on the surface of the solar cell precursor by coating; and
S23 - exposing an area in the mask not required to be provided with the opening, and adjusting a focal position and/or light intensity and/or wavelength of the exposure, such that absorption of exposure energy by the mask is gradually increased from the surface of the solar cell precursor in a direction away from the surface of the solar cell precursor, so as to form the development reaction area with width gradient in the mask; or exposing an area in the mask required to be provided with the opening, and adjusting a focal position and/or light intensity and/or wavelength of the exposure, such that absorption of exposure energy by the mask is gradually reduced from the surface of the solar cell precursor in a direction away from the surface of the solar cell precursor, so as to form the development reaction area with width gradient in the mask;
   or
S14 - forming a single layer of mask on the surface of the solar cell precursor by coating, a light transmission amount of the mask being progressively decreased with a thickness of penetration of the light through the mask; and
S24 - exposing an area in the mask not required to be provided with the opening, so as to form the development reaction area with width gradient in the mask.

In some embodiments, the preparation method for a grid line includes the following steps:
dividing the surface of the solar cell precursor into a first area and a second area;
preparing a first mask on the first area, and preparing a second mask on the second area;
exposing a local area of the first mask according to properties of the first mask, so as to form a first development reaction area with width gradient in the first mask;
developing the first mask in the first development reaction area, so as to form a first mask opening with width gradient in the first development reaction area;
electroplating a first metal in the first mask opening, so as to form a first grid line with width gradient;
exposing a local area of the second mask according to properties of the second mask, so as to form a second development reaction area with width gradient in the second mask;
developing the second mask in the second development reaction area, so as to form a second mask opening with width gradient in the second development reaction area; and
electroplating a second metal in the second mask opening, so as to form a second grid line with width gradient;
wherein the first metal and the second metal may be the same metal or different metals;
the first area and the second area are both located on the same surface of the solar cell precursor, or the first area and the second area are located on two surfaces of the solar cell precursor respectively.

**In** some embodiments, a side surface of a solar cell precursor is coated with a mask material, such that the mask material is cured to form a mask.

**In** some embodiments, the local area of the mask is exposed according to properties of the mask, so as to form a development reaction area with a trapezoidal or step-shaped vertical section in the mask;
the mask in the development reaction area is developed, so as to form a mask opening with a trapezoidal or step-shaped vertical section in the development reaction area; and
a metal is electroplated in the mask opening, so as to form the grid line with a trapezoidal or step-shaped vertical section.

In some embodiments, the mask opening has a trapezoidal vertical section, and the trapezoid has a base angle of 45-89 degrees.

In some embodiments, if the metal is electroplated in the mask opening, and a grid line with a triangular or trapezoidal vertical section cannot be formed; a surface of the grid line is covered with a reflecting layer or an alloy welding layer with a melting point lower than 300°C or an organic protective layer, such that the vertical section of the grid line is triangular or trapezoidal.

Another object of the present disclosure is to provide a preparation method for a photovoltaic cell, wherein a grid line on the solar cell precursor is prepared by adopting the following steps:
S1 - coating a mask material over a front surface and/or back surface of the solar cell precursor, and curing the mask material to form a mask;
S2 - exposing a local area of the mask according to properties of the mask, to form a development reaction area with width gradient in the mask;
S3 - developing the mask in the development reaction area, to form a mask opening with width gradient in the development reaction area;
S4 - electroplating a metal in the mask opening, to form the grid line with width gradient; and
S5 - removing the mask.

Still another object of the present disclosure is to provide a photovoltaic cell including a grid line with width gradient, which can reduce an optical width of the grid line.

In order to achieve the above object, the following technical solution is adopted in the embodiment of the disclosure: a photovoltaic cell includes a solar cell precursor and a grid line with width gradient provided on the solar cell precursor.

In some embodiments, the grid line has a triangular or trapezoidal or step-shaped vertical section.

In some embodiments, a surface of the grid line is also covered with a bright tin or bright silver reflecting layer; or
a surface of the grid line is covered with an alloy welding layer with a melting point lower than 300°C, and the alloy welding layer is formed by tin and one or more of lead, bismuth, silver, copper, indium and zinc; or
a surface of the grid line is covered with an organic protective layer.

In some embodiments, at least a light receiving surface of the solar cell precursor is provided with the grid line, or both surfaces of the solar cell precursor are provided with grid lines respectively.

In some embodiments, a plurality of grid lines on a same surface of the solar cell precursor are made of different metals, and/or a plurality of grid lines on different surfaces of the solar cell precursor are made of different metals.

In some embodiments, a minimum line width of the grid line is less than 50 microns and greater than or equal to 5 microns.

Due to the application of the above technical solution, compared with the conventional art, the embodiment of the disclosure has the following advantages: by using the preparation method for a grid line according to the embodiment of the present disclosure, the grid line with width gradient can be formed on the solar cell precursor, and after assembled in a photovoltaic module, the grid line with width gradient has a function of reflecting incident light at multiple angles; the reflected light can be reflected back to the surface of the solar cell precursor on a material interface in the photovoltaic module, thereby increasing the power generation efficiency . The preparation method for a grid line according to the embodiment of the disclosure has a simple process and is convenient for large-scale industrial application.

### BRIEF DESCRIPTION OF THE DRAWINGS

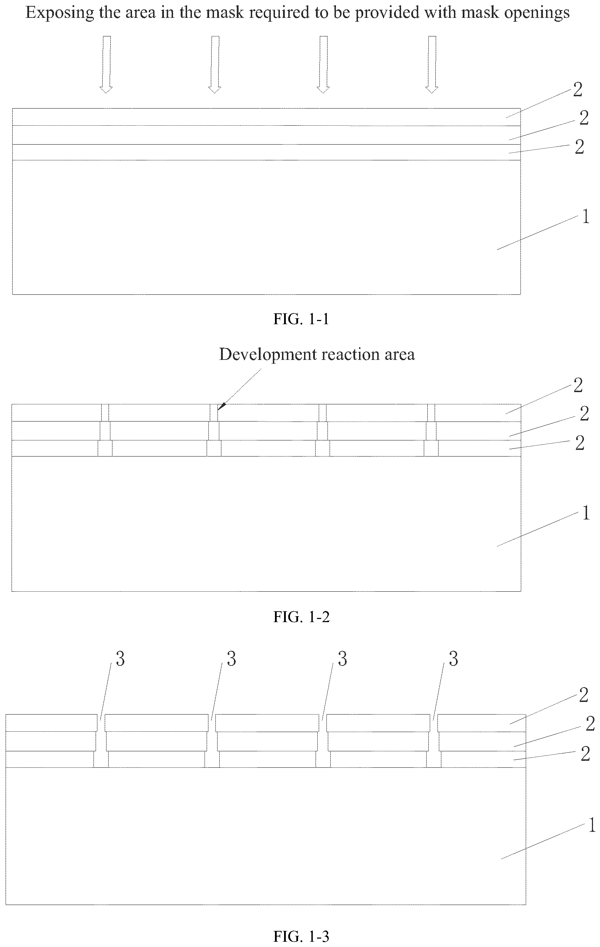

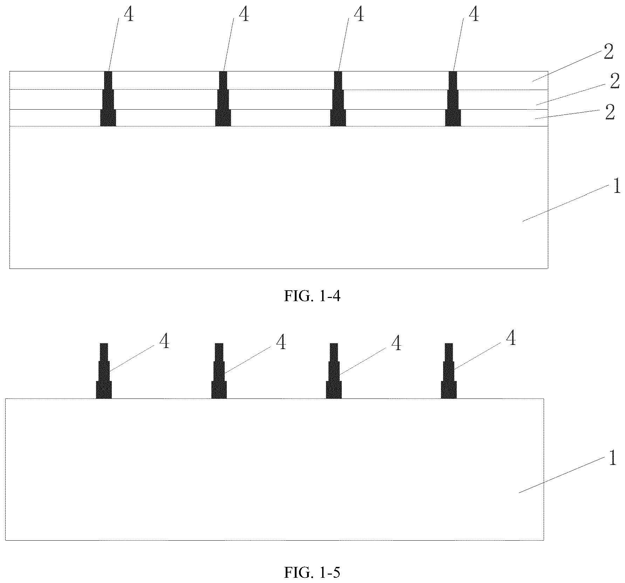

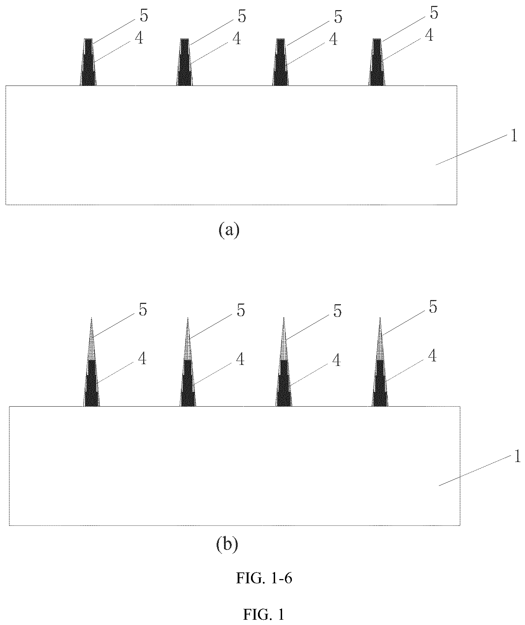

FIG. 1 is a schematic flow diagram of a preparation method for a grid line according to a first embodiment of the present disclosure;
FIG. 1-1 is a schematic diagram of illumination of mask exposure in the first embodiment of the present disclosure;
FIG. 1-2 is a schematic diagram of a development reaction area with width gradient in the first embodiment of the present disclosure;
FIG. 1-3 is a schematic diagram of a mask opening with width gradient in the first embodiment of the present disclosure;
FIG. 1-4 is a schematic diagram of the grid line with width gradient in the first embodiment of the present disclosure;
FIG. 1-5 is a schematic diagram of a solar cell precursor in the first embodiment of the present disclosure, wherein the mask is removed from the solar cell precursor;
FIG. 1-6 is a schematic diagram of the grid line covered with a film in the first embodiment of the present disclosure;
FIG. 2 is a schematic flow diagram of a preparation method for a grid line according to a second embodiment of the present disclosure;
FIG. 2-1 is a schematic diagram of illumination of mask exposure in the second embodiment of the present disclosure;
FIG. 2-2 is a schematic diagram of a development reaction area with width gradient in the second embodiment of the present disclosure;

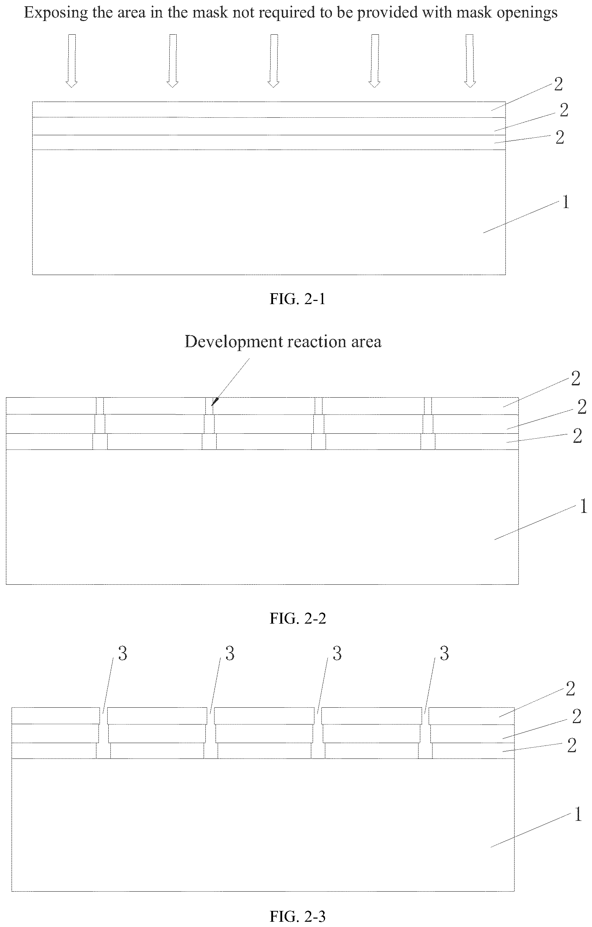

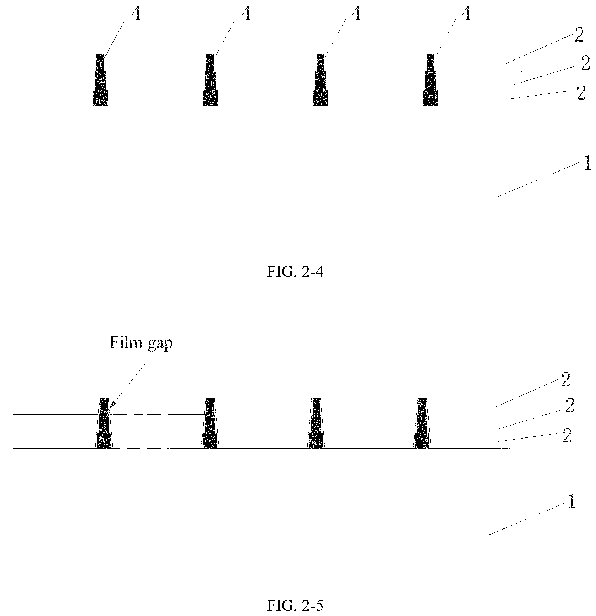

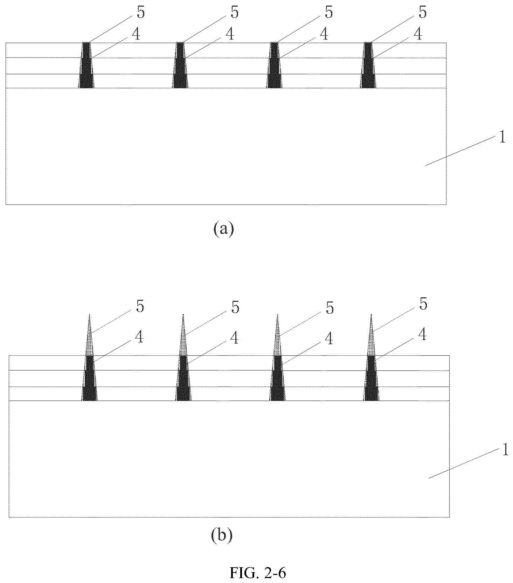

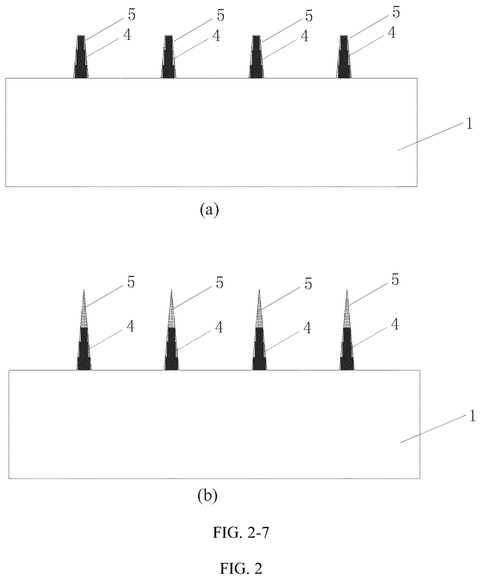

FIG. 2-3 is a schematic diagram of a mask opening with width gradient in the second embodiment of the present disclosure;
FIG. 2-4 is a schematic diagram of the grid line with width gradient in the second embodiment of the present disclosure;
FIG. 2-5 is a schematic diagram of film gap in the second embodiment of the present disclosure;
FIG. 2-6 is a schematic diagram of the grid line covered with a film in the second embodiment of the present disclosure;
FIG. 2-7 is a schematic diagram of a solar cell precursor in the second embodiment of the present disclosure, wherein the mask is removed from the solar cell precursor;

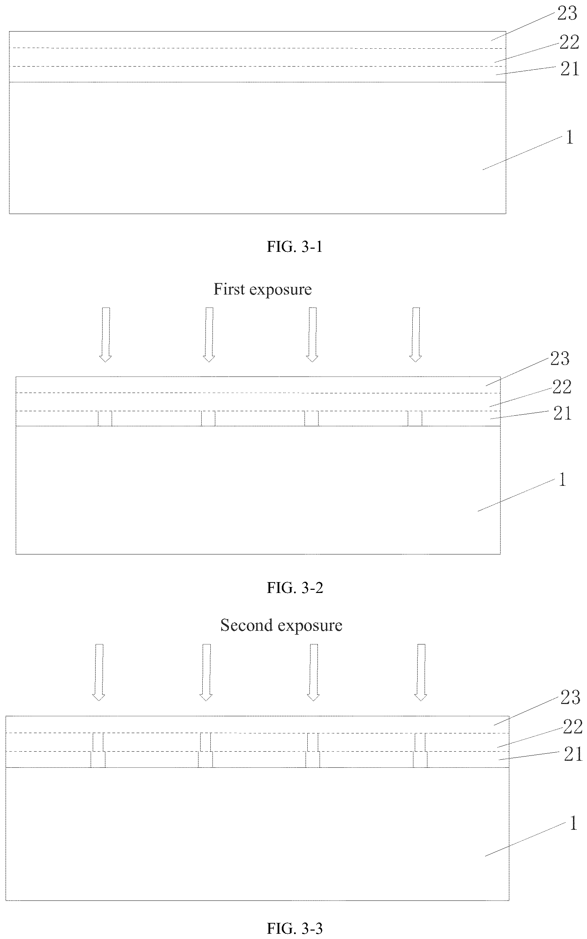

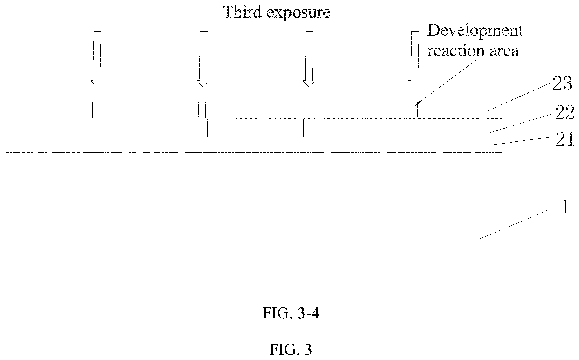

FIG. 3 is a schematic flow diagram of a preparation method for a development reaction area in a third embodiment of the present disclosure;
FIG. 3-1 is a schematic structural diagram of a solar cell precursor covered with a mask in the third embodiment of the present disclosure;
FIG. 3-2 is a schematic diagram of the third embodiment of the present disclosure after the first exposure;
FIG. 3-3 is a schematic diagram of the third embodiment of the present disclosure after the second exposure;
FIG. 3-4 is a schematic diagram of the third embodiment of the present disclosure after the third exposure;

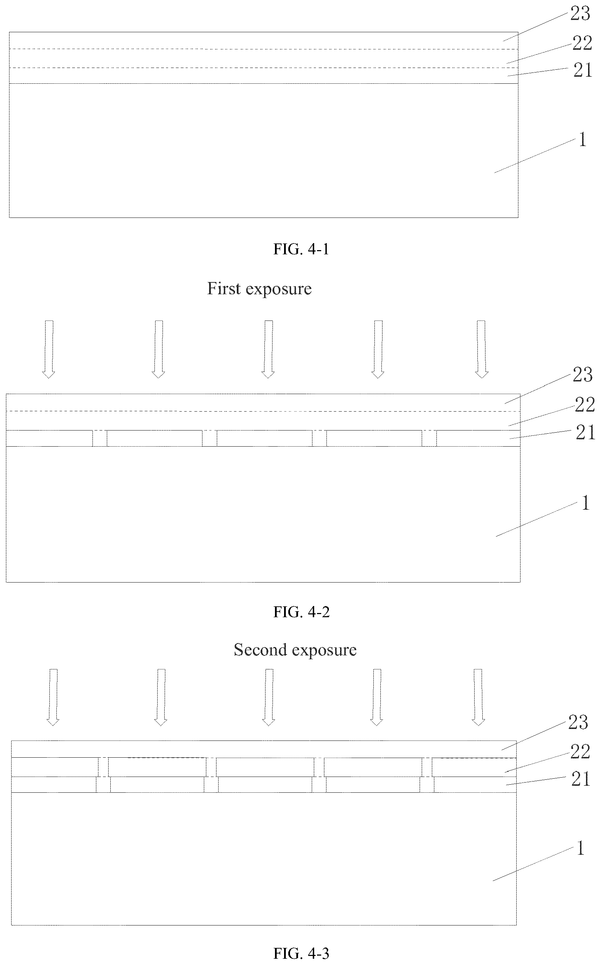

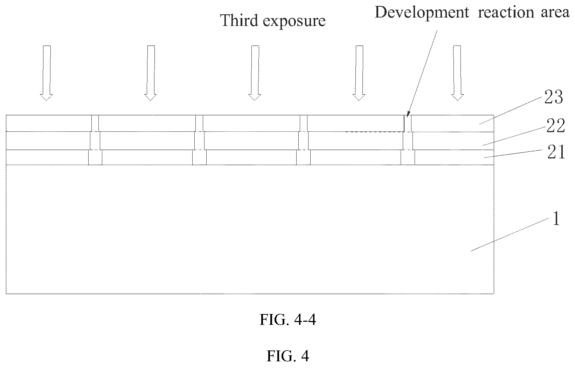

FIG. 4 is a schematic flow diagram of a preparation method for a development reaction area in a fourth embodiment of the present disclosure;
FIG. 4-1 is a schematic structural diagram of a solar cell precursor covered with a mask in the fourth embodiment of the present disclosure;
FIG. 4-2 is a schematic diagram of the fourth embodiment of the present disclosure after the first exposure;
FIG. 4-3 is a schematic diagram of the fourth embodiment of the present disclosure after the second exposure;
FIG. 4-4 is a schematic diagram of the fourth embodiment of the present disclosure after the third exposure;

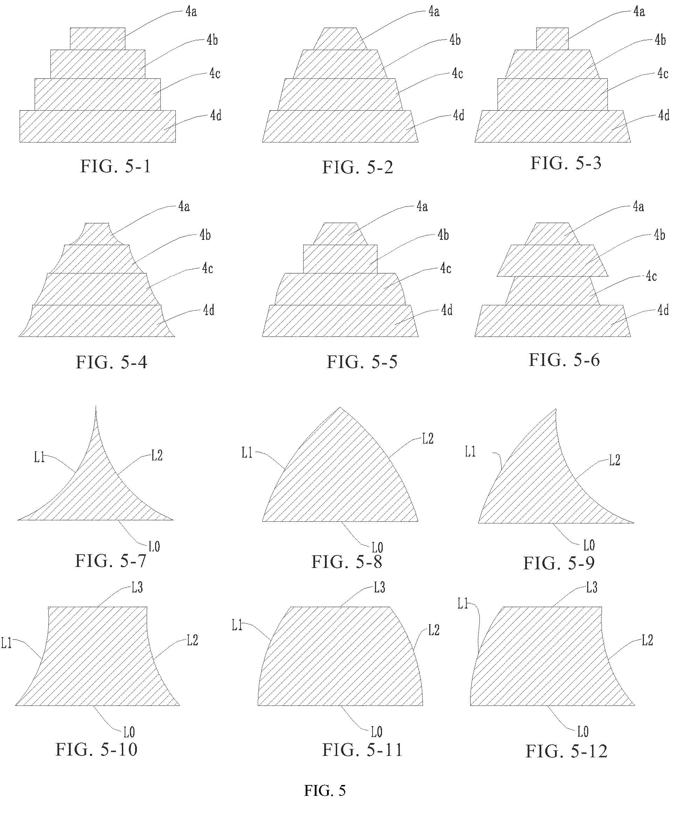

FIG. 5 is schematic diagrams of vertical sections of grid lines with width gradient in a fifth embodiment of the present disclosure;

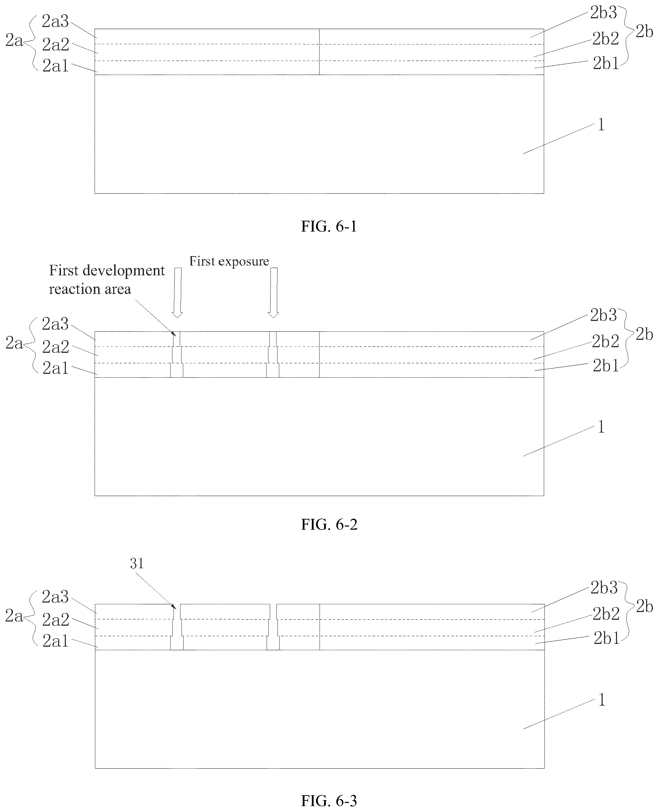

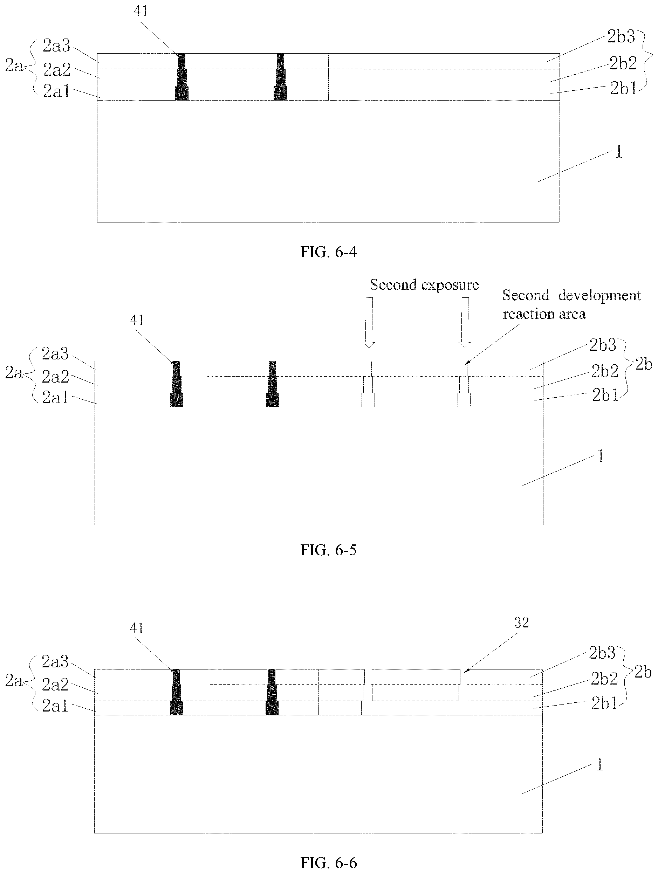

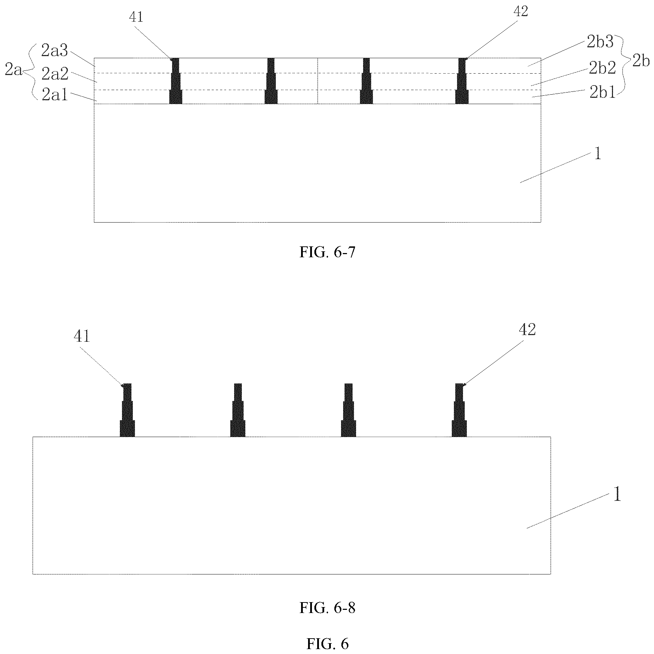

FIG. 6 is a schematic flow diagram of a preparation method for a grid line according to a sixth embodiment of the present disclosure;
FIG. 6-1 is a schematic structural diagram of a solar cell precursor covered with a mask in the sixth embodiment of the present disclosure;
FIG. 6-2 is a schematic diagram of a first mask after the first exposure in the sixth embodiment of the present disclosure;
FIG. 6-3 is a schematic diagram of a first mask opening in the first mask in the sixth embodiment of the present disclosure;
FIG. 6-4 is a schematic diagram of a first grid line in the first mask in the sixth embodiment of the present disclosure;
FIG. 6-5 is a schematic diagram of a second mask after the second exposure in the sixth embodiment of the present disclosure;
FIG. 6-6 is a schematic diagram of a second mask opening in the second mask in the sixth embodiment of the present disclosure;
FIG. 6-7 is a schematic diagram of a second grid line in the second mask in the sixth embodiment of the present disclosure;
FIG. 6-8 is a schematic structural diagram of the solar cell precursor in the sixth embodiment of the present disclosure, wherein the mask is removed from the solar cell precursor;

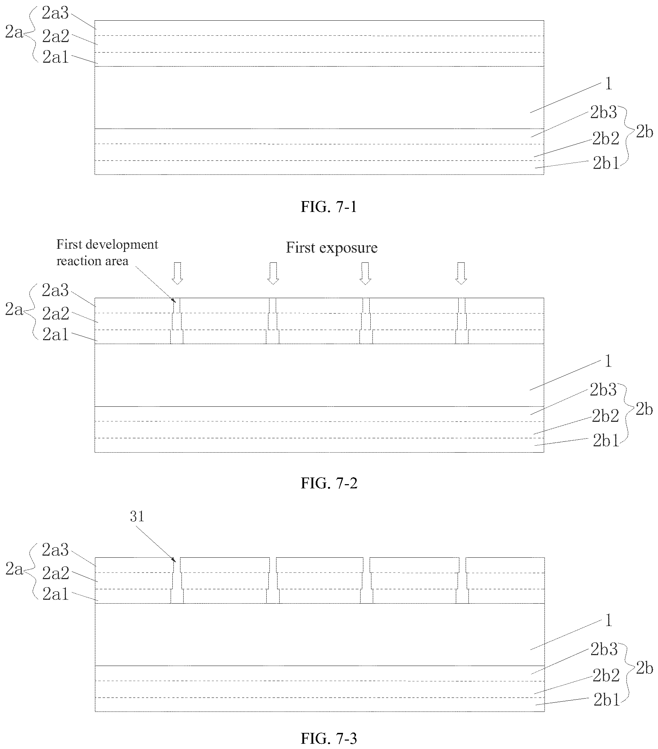

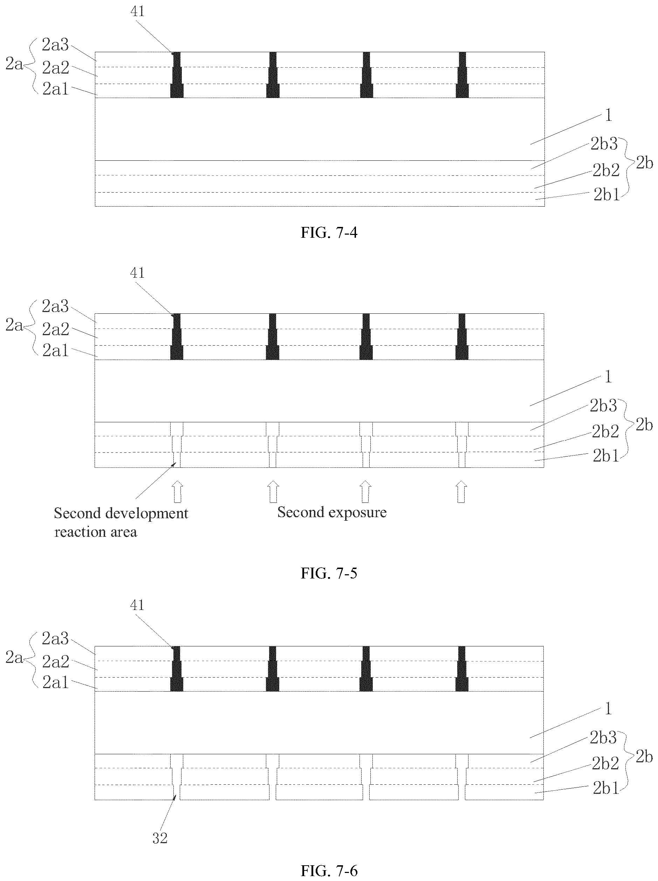

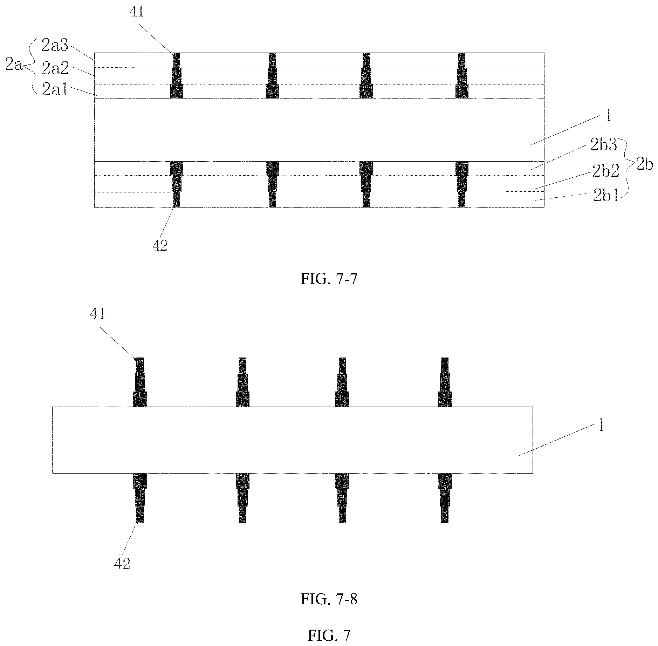

FIG. 7 is a schematic flow diagram of a preparation method for a grid line according to a seventh embodiment of the present disclosure;
FIG. 7-1 is a schematic structural diagram of a solar cell precursor covered with a mask in the seventh embodiment of the present disclosure;
FIG. 7-2 is a schematic diagram of an exposure result of a first mask in the seventh embodiment of the present disclosure;
FIG. 7-3 is a schematic diagram of a first mask opening in the first mask in the seventh embodiment of the present disclosure;
FIG. 7-4 is a schematic diagram of a first grid line in the first mask in the seventh embodiment of the present disclosure;
FIG. 7-5 is a schematic diagram of an exposure result of a second mask in the seventh embodiment of the present disclosure;
FIG. 7-6 is a schematic diagram of a second mask opening in the second mask in the seventh embodiment of the present disclosure;
FIG. 7-7 is a schematic diagram of a second grid line in the second mask in the seventh embodiment of the present disclosure; and
FIG. 7-8 is a schematic structural diagram of the solar cell precursor in the seventh embodiment of the present disclosure, wherein the mask is removed from the solar cell precursor.

In the drawings: 1 - solar cell precursor; 2 - mask; 21 - first layer; 22 - second layer; 23 - third layer; 2a1 - first layer of the first mask; 2a2 - second layer of the first mask; 2a3 - third layer of the first mask; 2b1 - first layer of the second mask; 2b2 - second layer of the second mask; 2b3 - third layer of the second mask; 3 - mask opening; 4 - grid line; 4a - first layer (top layer); 4b - second layer; 4c - third layer; 4d - fourth layer; L0 - base; L1 - lateral side; L2 - lateral side; L3 - top side; 5 - covering layer.

### DETAILED DESCRIPTION

A grid line of a photovoltaic cell is prepared by printing silver paste via silk-screen. The silver paste is transferred onto a substrate after passing through the openings prefabricated in the screen to form an unsolidified grid line; when the screen is separated from the substrate, the unsolidified grid line in contact with a yarn of the screen is lifted; and after the screen is separated from the substrate, since the unsolidified grid line has certain leveling property, a vertical section of a finally formed grid line is in a shape similar to a semi-circular arc with a wide lower part and a narrow upper part, and the formed grid line is called a circular arc-shaped grid line. After assembled in a photovoltaic module, the circular arc-shaped grid line has a function of reflecting incident light at multiple angles, and the reflected light has a certain probability of being reflected back to a surface of a solar cell precursor on a material interface in the photovoltaic module, thereby increasing power generation efficiency (photoelectric conversion efficiency), which is called a reflection increasing effect.

In order to further reduce cost of the photovoltaic cell and improve efficiency of the cell, using copper electroplating instead of silver paste printing to prepare the grid line of the photovoltaic cell gets more and more attention and research. When the copper electroplating process is adopted to replace the silver paste printing process to prepare the grid line, a mask opening for electroplating copper is usually rectangular or approximately rectangular, such that the vertical section of the formed grid line is rectangular or approximately rectangular, and the grid line is called rectangular grid line. However, the rectangular grid line cannot increase reflection from the surface of the grid line in multi-directions, and therefore, there is an assembling loss more than that of the circular arc-shaped grid line after assembled in the photovoltaic module, thus affecting the power generation efficiency and the power generation amount in a life cycle. The reflection increasing effect of the circular arc-shaped grid line is characterized by an optical width of the grid line which is usually 70% of a width of a physically widest part of the grid line; the optical width of the rectangular grid line is typically more than 90% of the width of the physically widest part thereof.

Therefore, the present disclosure provides a preparation method for a grid line, a preparation method for a photovoltaic cell, and a photovoltaic cell, which reduce the optical width of the grid line to improve the photoelectric conversion efficiency of the photovoltaic cell.

On the other hand, preparing silver grid line by the traditional silk-screen printing process mainly has the following problems: firstly, it is needed to press the solar cell precursor in the printing process, which is prone to increase the damage rate of the solar cell precursor with a thickness less than 100 microns. Secondly, the resolution of silk-screen printing is low, and the printed silver grid line has a low ratio of height to width. It is quite difficult to reduce a current line width to below 50 microns due to the presence of a mesh thread of a silk screen, and in order to enable the silver paste to pass through the silk screen without break, the silver paste must have certain fluidity, such that the printed silver grid line before solidification will flow outwards, and therefore, the line width (width of a contact surface between the grid line and the solar cell precursor) is further increased, the ratio of height to width is reduced, the shading area is increased, and the photoelectric conversion efficiency is affected. Therefore, it is necessary to provide a preparation method for a grid line, a preparation method for a photovoltaic cell and a photovoltaic cell, which can prepare a grid line with a low width, reduce the shading area of the grid line, and improve the photoelectric conversion efficiency of the photovoltaic cell.

The method of measuring the quantum efficiency of the photovoltaic cell is used, and by measuring the quantum efficiency of generating carriers by the laminated photovoltaic cell for light with different wavelengths, and in conjunction with integrating the energy of the light with different wavelengths in a solar spectrum, a short-circuit current of a certain area of the photovoltaic cell covered by a light spot is calculated.

When a certain area contains certain grid lines, the short-circuit current can be reduced by shading of the grid line, and a reduction proportion is in direct proportion to a shading area.

For example, when the short-circuit current of a shading-free area is 40mA/cm², if an optical shading area of 2% is introduced in the area, the short-circuit current would be 39.2mA/cm². When a widest part of a grid line with width gradient of the photovoltaic cell generates a physical shading area of 3% in the area, it can be concluded that the optical width of the grid line is 2%/3%=66% of a width of a physically widest part thereof.

As another example, if one grid line has no width gradient, when the short-circuit current of the shading-free area is 40mA/cm² and the physical shading area formed by the grid line is 3%, that is, an optical shading area of 3% is formed, the short-circuit current is 38.8mA/cm². If one grid line has width gradient, when the short-circuit current of the shading-free area is 40mA/cm², and the physical shading area is 3%, the optical shading area of only 2% is actually generated, and therefore, the generated short-circuit current is 39.2mA/cm². Under the same condition, the short-circuit current generated by the photovoltaic cell with the grid line with width gradient is larger than that generated by the photovoltaic cell with the grid line without width gradient; that is, the photoelectric conversion efficiency of the photovoltaic cell with the grid line with width gradient is higher.

The technical solution of the present disclosure is further explained below with reference to the drawings and the specific embodiments.

As shown in FIG. 1 or FIG. 2, an embodiment of the present disclosure provides a preparation method for a grid line, including the following steps:
S1 - coating a mask material over a front surface and/or back surface of a solar cell precursor 1, and curing the mask material to form a mask 2;
S2 - exposing a local area of the mask 2 according to properties of the mask 2, to form a development reaction area with width gradient in the mask 2;
S3 - developing the mask 2 in the development reaction area, to form a mask opening 3 with width gradient in the development reaction area;
S4 - electroplating a metal in the mask opening 3, to form the grid line 4 with width gradient; and
S5 - removing the mask 2.

In the preparation method for a grid line according to the embodiment of the disclosure, the grid line 4 with width gradient can be formed on the surface of the solar cell precursor 1, and when the solar cell precursor 1 is used, especially after the solar cell precursor is assembled in a photovoltaic module, the grid line 4 with width gradient can reflect incident light at multiple angles, such that the incident light can be reflected back to the surface of the solar cell precursor 1 again from a material interface of the photovoltaic module, thereby increasing the power generation efficiency of the photovoltaic cell.

For the existing screen printing technology, the grid line 4 with width gradient cannot be directly printed, and even if the grid line 4 with width gradient is obtained accidentally, width gradients of grid lines 4 on the same solar cell precursor 1 are different or inconsistent, such that the reflection increasing effect is reduced. In the preparation method for a grid line according to the embodiment of the present disclosure, the mask openings 3 with a consistent width gradient can be obtained by a photolithography (development and exposure) method, the metal is then electroplated in the mask openings 3 with a consistent width gradient, and the grid lines 4 with a consistent width gradient can be obtained, thus obtaining a good reflection increasing effect.

The grid line 4 with width gradient having a good reflection increasing effect or a complex vertical section (for example, various vertical sections with width gradient shown in FIG. 5) cannot be directly printed, while the required mask opening 3 can be obtained by the photolithography (development and exposure) method, the metal is then electroplated in the required mask opening 3, and the grid line 4 with width gradient having a good reflection increasing effect or a complex vertical section can be obtained.

Definition: the two surfaces perpendicular to the thickness direction of the solar cell precursor 1 are the front surface and the back surface, or the two opposite larger surfaces of the solar cell precursor 1 are the front surface and the back surface; the surface extending in the thickness direction of the solar cell precursor 1 is a side surface, or the surface other than the front surface and the back surface is a side surface. The light receiving surface of the solar cell precursor 1 refers to one surface or both surfaces of the solar cell precursor 1 which can receive light to generate electricity in use, and may be the front surface and/or the back surface.

It should be noted that exposure refers to a photochemical reaction process in which the mask 2 and the light are photocrosslinked, photopolymerized, or photodecomposed. Development refers to a process in which the mask 2 which does not undergo a photochemical reaction or undergoes a photochemical reaction further reacts with a developer to generate the mask opening 3.

It should be noted that the width gradient refers to the phenomenon that the width value of an object changes from top to bottom along the up-down direction of the object, and if the object is divided into a plurality of layers sequentially distributed from top to bottom, at least one width-expanded layer exists below a top layer, and the width of the width-expanded layer is greater than the width of any one of the layers above the width-expanded layer. Specifically, the object is divided into a 1st layer, a 2nd layer,..., and an Nth layer from top to bottom in sequence, N is a positive integer greater than 1, the 1st layer is the top layer, and the Nth layer is a bottom layer adjacent to the surface of the solar cell precursor. The above width-expanded layer is a relative concept, and if the width of the 2nd layer is larger than the width of the 1st layer, the 2nd layer is the width-expanded layer; if the width of the 4th layer is greater than the width of any one of the 1st to 3rd layers, the 4th layer is the width-expanded layer.

The comparatively representative width gradient is the phenomenon that the width value of the object is gradually increased from top to bottom, and especially, the vertical section has a triangular shape, a trapezoidal shape with a narrow upper part and a wide lower part, or a step shape with a narrow upper part and a wide lower part. For example, if the vertical section of the development reaction area has a trapezoidal shape with a narrow upper part and a wide lower part or a step shape with a narrow upper part and a wide lower part, the development reaction area can be considered to have width gradient. If the vertical section of the mask opening 3 has a trapezoidal shape with a narrow upper part and a wide lower part or a step shape with a narrow upper part and a wide lower part, the mask opening 3 can be considered to have width gradient. If the vertical section of the grid line 4 has a triangular shape, a trapezoidal shape with a narrow upper part and a wide lower part or a step shape with a narrow upper part and a wide lower part, the grid line 4 can be considered to have width gradient. Certainly, the width gradient of the object includes, but is not limited to, the above examples.

In some embodiments, the mask 2 may be made of an acid-resistant material, and the mask 2 may be soaked to be removed by an alkaline solution, such as an alkaline solution formed of at least one of sodium hydroxide, potassium hydroxide, or calcium hydroxide.

In some embodiments, the preparation method further includes step S6 - covering a surface of the grid line 4 with a reflecting layer or an alloy welding layer with a melting point lower than 300°C or an organic protective layer, the reflecting layer, the alloy welding layer and the organic protective layer being referred to as a covering layer 5, wherein the step S6 is after the step S4 and before the step S5, or the step S6 is after the step S5. The alloy welding layer is formed by tin and one or more of lead, bismuth, silver, copper, indium and zinc. The surface of the grid line 4 is covered with the above-mentioned reflecting layer, alloy welding layer or organic protective layer, such that the whole grid line 4 can be formed into an approximately triangular or trapezoidal shape after the reflecting layer, alloy welding layer or organic protective layer is heated and melted to flow back.

In the step S6, the surface of the grid line 4 is covered with the reflecting layer, alloy welding layer or organic protective layer, such that the functions of improving the reflecting effect of the surface of the grid line 4, improving the welding performance of the surface of the grid line 4, or protecting the surface of the grid line 4 from chemical corrosion are correspondingly achieved, and meanwhile, the surface of the grid line 4 is flatter and smoother, thus improving the reflection increasing effect of the grid line 4. Particularly, when the grid line 4 obtained in the step S5 has a step shape, the reflecting layer, alloy welding layer or organic protective layer may be used as a compensation material to compensate for a step space on the grid line 4, such that the vertical section of the grid line 4 is formed into an approximately triangular or trapezoidal shape, thereby improving the reflection increasing effect of the grid line 4. The reflecting layer, alloy welding layer or organic protective layer covering the surface of the grid line 4 can be prepared by electroplating, chemical plating or coating.

Specifically, as shown in FIG. 1, the step S6 may be performed after the step S5 is completed; that is, after the mask 2 is removed, the surface of the grid line 4 is covered with the reflecting layer, alloy welding layer or organic protective layer, such that the reflecting layer, alloy welding layer or organic protective layer can be more conveniently formed, interference of the mask 2 is avoided, and the preparation efficiency of the grid line 4 is improved. As shown in FIG. 2, the step S6 may also be after the step S4 and before the step S5; that is, the surface of the grid line 4 is covered with the reflecting layer, alloy welding layer or organic protective layer, and then, the mask 2 is removed. In this solution, there may not be an enough film gap between the grid line 4 and the mask opening 3 for accommodating the reflecting layer, alloy welding layer or organic protective layer, and in order to smoothly cover the surface of the grid line 4 with the reflecting layer, alloy welding layer or organic protective layer, a mask-removing solution is adopted to soak or is injected in advance to a connection position between the grid line 4 and the mask opening 3 to obtain the film gap, the surface of the grid line 4 is then covered with the reflecting layer, alloy welding layer or organic protective layer, and finally, the mask 2 is removed; therefore, the grid line 4 can be protected by the layer in advance, and damage to the grid line 4 in a next process can be avoided.

In some embodiments, the two surfaces (front surface and back surface) of the solar cell precursor 1 are coated with the mask material, the masks 2 are formed on the two surfaces of the solar cell precursor 1, and the grid line 4 with width gradient is formed on at least the light receiving surface of the solar cell precursor 1; when the solar cell precursor 1 has a double-sided power generation structure, the grid lines 4 with width gradient are formed on both surfaces of the solar cell precursor 1.

Specifically, the two surfaces (front surface and back surface) of the solar cell precursor 1 are coated with the mask material, and the masks 2 are formed on the two surfaces of the solar cell precursor 1. If the solar cell precursor 1 is a single-sided power generation structure, that is, only one surface (front surface or back surface) of the solar cell precursor is the light receiving surface, only part of the mask 2 on the light receiving surface is exposed and developed to form the mask opening 3 with width gradient, and the metal is then electroplated in the mask opening 3 with width gradient to form the grid line 4 with width gradient. If the solar cell precursor 1 is a double-sided power generation structure, that is, both surfaces (front surface and back surface) of the solar cell precursor are light receiving surfaces, parts of the masks 2 on both surfaces of the solar cell precursor 1 are exposed and developed to form the mask openings 3 with width gradient on both surfaces of the solar cell precursor 1 respectively, and the metal is then electroplated in the mask openings 3 with width gradient to form grid lines 4 with width gradient on both surfaces of the solar cell precursor 1 respectively. In the process of forming the grid line 4 by electroplating, non-opening areas on the two surfaces of the solar cell precursor 1 are also electroplated if directly contacting an electroplating solution, and therefore, no matter whether the solar cell precursor 1 is a double-sided power generation structure, the masks 2 are required to be formed on the two surfaces of the solar cell precursor 1, so as to prevent the non-opening areas on the two surfaces of the solar cell precursor 1 from being electroplated.

It should be noted that the solar cell precursor 1 of a single-sided power generation structure mentioned in the embodiment of the present application may be a BSF (Aluminium Back Surface Field) cell, a PERC (Passivated Emitter and Rear Cell), an HJT (Heterojunction with Intrinsic Thin Layer) cell, a PSC (Perovskite Solar cell), an IBC (Interdigitated Back Contact) cell, or the like. The solar cell precursor 1 of a double-sided power generation structure mentioned in the embodiment of the present application may be an HJT cell, a Topcon (Tunnel Oxide Passivating Contact) cell, a PSC, or the like.

**In** some embodiments, the development reaction area with width gradient may be formed at least by the following method: exposing an area in the mask 2 not required to be provided with the opening, such that a curing degree of the mask 2 is gradually increased from a surface of the solar cell precursor 1 in a direction away from the surface of the solar cell precursor 1, so as to form the development reaction area with width gradient in the mask 2; or exposing an area in the mask 2 required to be provided with the opening, such that a curing degree of the mask 2 is gradually reduced from a surface of the solar cell precursor 1 in a direction away from the surface of the solar cell precursor 1, so as to form the development reaction area with width gradient in the mask 2.

The mask opening 3 with width gradient can be formed at least by the following method: according to the situation that the curing degree of the mask 2 is gradually increased or gradually reduced from the surface of the solar cell precursor 1 in the direction away from the surface of the solar cell precursor 1, selecting a corresponding developer for a development reaction with the mask 2 in the development reaction area with width gradient, the development reaction having a reaction rate gradually reduced from the surface of the solar cell precursor 1 in the direction away from the surface of the solar cell precursor 1, such that the mask opening 3 with width gradient is formed.

In some embodiments, the development reaction area with width gradient is formed by the following method: forming multiple layers of masks 2 on a surface of the solar cell precursor 1 by coating, the multiple layers of masks 2 having different photosensibilities; and exposing areas in the multiple layers of masks 2 not required to be provided with openings, such that curing degrees of the multiple layers of masks 2 are increased layer by layer from the surface of the solar cell precursor 1 in a direction away from the surface of the solar cell precursor 1, so as to form development reaction areas with width gradient in the masks 2; or exposing areas in the multiple layers of masks 2 required to be provided with openings, such that curing degrees of the multiple layers of masks 2 are reduced layer by layer from the surface of the solar cell precursor 1 in a direction away from the surface of the solar cell precursor 1, so as to form the development reaction areas with width gradient in the masks 2; concentration of a photosensitive component and/or a photosensitive ingredient being adjusted to form the multiple layers of masks 2 having different photosensibilities. In the above embodiments, a uniform light can be used for one-time exposure, the exposure process is simple, and the exposure efficiency is higher.

Exemplarily, as shown in FIG. 1, three masks 2 are formed on the surface of the solar cell precursor 1 by coating, the masks 2 have different photosensibilities, and the photosensibilities of the three masks 2 are decreased layer by layer from the surface of the solar cell precursor 1 in the direction away from the surface of the solar cell precursor 1; that is, the photosensibility of the mask 2 (bottommost) close to the surface of the solar cell precursor 1 is highest, the photosensibility of the mask 2 (uppermost) away from the surface of the solar cell precursor 1 is lowest, and the photosensibility of the mask 2 in the middle is less than the photosensibility of the adjacent lower mask 2 but greater than the photosensibility of the adjacent upper mask 2. The three masks are exposed simultaneously by the same light beam, the areas on the three masks 2 required to be provided with openings are exposed, and durations of exposure are the same; among all the multiple masks 2, the bottommost mask 2 has a highest photosensibility and absorbs most energy of light, such that the bottommost mask 2 has a highest curing degree and a largest cured area (i.e., a volume of the largest cured part of the mask 2); the uppermost mask 2 has a lowest photosensibility and absorbs least energy of the light, such that the uppermost mask 2 has a lowest curing degree and a smallest cured area (i.e., a volume of the smallest cured part of the mask 2); the mask 2 in the middle has a photosensibility smaller than that of the adjacent lower mask 2 but larger than that of the adjacent upper mask 2, such that the mask 2 in the middle has a curing degree and a cured area smaller than those of the adjacent lower mask 2 and larger than those of the adjacent upper mask 2; that is, the cured areas are decreased layer by layer from the surface of the solar cell precursor 1 in the direction away from the surface of the solar cell precursor 1; that is, the step-shaped development reaction area shown in FIG. 1-2 is formed.

Exemplarily, a coordinate system is established with the surface of the solar cell precursor 1 as an origin, the photosensibility is a dependent variable y, a number of the multiple masks 2 counted upwards from the surface of the solar cell precursor 1 is an independent variable x, and when the number x is 1, the photosensibility thereof is assumed to be b, and then, a calculation formula *y□□axⁿ □b* of the photosensibility y can be obtained, wherein a and n depend on properties of the mask 2, and a is a positive number determined mainly by the concentration of the photosensitive component and/or the photosensitive ingredient in the mask 2. In theory, when n is 1, sections of the development reaction areas formed after exposure of the multiple masks 2 substantially have a step shape, and reference may be exemplarily made to the patterns in FIG. 5-1 and FIG. 5-2.

Exemplarily, a coordinate system is established with the surface of the solar cell precursor 1 as an origin, the photosensibility is a dependent variable y, a distance between the mask 2 and the surface of the solar cell precursor 1 is an independent variable x, that is, a height of the mask 2 on the solar cell precursor 1 is x, and when the height is 0, the mask 2 is in contact with the surface of the solar cell precursor 1, the photosensibility thereof is assumed to be b, and then, a calculation formula *y□□axⁿ □b* of the photosensibility y can be obtained, wherein a and n depend on properties of the mask 2, and a is a positive number determined mainly by the concentration of the photosensitive component and/or the photosensitive ingredient in the mask 2. In theory, when n is 1, a section of the development reaction area formed after exposure of the mask 2 substantially has a trapezoid shape or triangular shape.

Exemplarily, as shown in FIG. 2, three masks 2 are formed on the surface of the solar cell precursor 1 by coating, the masks 2 have different photosensibilities, and the photosensibilities of the three masks 2 are increased layer by layer from the surface of the solar cell precursor 1 in the direction away from the surface of the solar cell precursor 1; that is, the photosensibility of the mask 2 (bottommost) close to the surface of the solar cell precursor 1 is lowest, the photosensibility of the mask 2 (uppermost) away from the surface of the solar cell precursor 1 is highest, and the photosensibility of the mask 2 in the middle is larger than the photosensibility of the adjacent lower mask 2 but smaller than the photosensibility of the adjacent upper mask 2. The three masks are exposed simultaneously by the same light beam, the areas on the three masks 2 not required to be provided with openings are exposed, and durations of exposure are the same; among all the multiple masks 2, the bottommost mask 2 has a lowest photosensibility and absorbs least energy of light, such that the bottommost mask 2 has a lowest curing degree and a smallest cured area (i.e., a volume of the smallest cured part of the mask 2); the uppermost mask 2 has a highest photosensibility and absorbs most energy of the light, such that the uppermost mask 2 has a highest curing degree and a largest cured area (i.e., a volume of the largest cured part of the mask 2); the mask 2 in the middle has a photosensibility larger than that of the adjacent lower mask 2 but smaller than that of the adjacent upper mask 2, such that the mask 2 in the middle has a curing degree and a cured area larger than those of the adjacent lower mask 2 and smaller than those of the adjacent upper mask 2; that is, the cured areas of the multiple masks 2 are increased layer by layer from the surface of the solar cell precursor 1 in the direction away from the surface of the solar cell precursor 1, exposure points on the same mask 2 are arranged at intervals, the cured areas formed by the adjacent exposure points arranged at intervals are not overlapped, an uncured area is formed between every two adjacent cured areas, and the uncured areas are decreased layer by layer from the surface of the solar cell precursor 1 in the direction away from the surface of the solar cell precursor 1; that is, the step-shaped development reaction area shown in FIG. 2-2 is formed.

Exemplarily, a coordinate system is established with the surface of the solar cell precursor 1 as an origin, the photosensibility is a dependent variable y, a number of the multiple masks 2 counted upwards from the surface of the solar cell precursor 1 is an independent variable x, and when the number x is 1, the photosensibility thereof is assumed to be a+b, and then, a calculation formula *y□axⁿ □b* of the photosensibility y can be obtained, wherein a and n depend on properties of the mask 2, and a is a positive number determined mainly by the concentration of the photosensitive component and/or the photosensitive ingredient in the mask 2. In theory, when n is 1, sections of the development reaction areas formed after exposure of the multiple masks 2 substantially have a step shape, and reference may be exemplarily made to the patterns in FIG. 5-1 and FIG. 5-2.

Exemplarily, a coordinate system is established with the surface of the solar cell precursor 1 as an origin, the photosensibility is a dependent variable y, a distance between the mask 2 and the surface of the solar cell precursor 1 is an independent variable x, that is, a height of the mask 2 on the solar cell precursor 1 is x, and when the height is 0, the mask 2 is in contact with the surface of the solar cell precursor 1, the photosensibility thereof is assumed to be a+b, and then, a calculation formula *y□axⁿ □b* of the photosensibility y can be obtained, wherein a and n depend on properties of the mask 2, and a is a positive number determined mainly by the concentration of the photosensitive component and/or the photosensitive ingredient in the mask 2. In theory, when n is 1, a section of the development reaction area formed after exposure of the mask 2 substantially has a trapezoid shape or triangular shape.

In some embodiments, the development reaction area with width gradient is formed by the following method: forming multiple layers of masks 2 on a surface of the solar cell precursor 1 by coating, the masks 2 having different absorption peak values; and exposing areas in the multiple layers of masks 2 not required to be provided with openings, such that curing degrees of the multiple layers of masks 2 are increased layer by layer from the surface of the solar cell precursor in a direction away from the surface of the solar cell precursor 1, so as to form the development reaction areas with width gradient in the masks 2; or exposing areas in the multiple layers of masks 2 required to be provided with openings, such that curing degrees of the multiple layers of masks 2 are reduced layer by layer from the surface of the solar cell precursor 1 in a direction away from the surface of the solar cell precursor 1, so as to form the development reaction areas with width gradient in the masks 2.

Exemplarily, as shown in FIG. 1, three masks 2 are formed on the surface of the solar cell precursor 1 by coating, the masks 2 have different absorption peak values, light in a band range (for example, 380nm-410nm) is selected, and sensitivities of the three masks 2 to the light in the selected band range are decreased layer by layer from the surface of the solar cell precursor 1 in the direction away from the surface of the solar cell precursor 1; that is, the sensitivity of the mask 2 (bottommost) close to the surface of the solar cell precursor 1 to the light in the selected band range is highest, the sensitivity of the mask 2 (uppermost) away from the surface of the solar cell precursor 1 to the light in the selected band range is lowest, and the sensitivity of the mask 2 in the middle to the light in the selected band range is less than the sensitivity of the adjacent lower mask 2 to the light in the selected band range but greater than the sensitivity of the adjacent upper mask 2 to the light in the selected band range. The three masks are exposed simultaneously by the same light beam, the areas on the three masks 2 required to be provided with openings are exposed, and durations of exposure are the same; among all the multiple masks 2, the bottommost mask 2 has a highest sensitivity to the light in the selected band range and absorbs most energy of the light, such that the bottommost mask 2 has a highest curing degree and a largest cured area (i.e., a volume of the largest cured part of the mask 2); the uppermost mask 2 has a lowest sensitivity to the light in the selected band range and absorbs least energy of the light, such that the uppermost mask 2 has a lowest curing degree and a smallest cured area (i.e., a volume of the smallest cured part of the mask 2); the mask 2 in the middle has a sensitivity to the light in the selected band range smaller than that of the adjacent lower mask 2 but larger than that of the adjacent upper mask 2, such that the mask 2 in the middle has a curing degree and a cured area smaller than those of the adjacent lower mask 2 and larger than those of the adjacent upper mask 2; that is, the cured areas are decreased layer by layer from the surface of the solar cell precursor 1 in the direction away from the surface of the solar cell precursor 1; that is, the step-shaped development reaction area shown in FIG. 1-2 is formed.

Exemplarily, as shown in FIG. 2, three masks 2 are formed on the surface of the solar cell precursor 1 by coating, the masks 2 have different absorption peak values, light in a band range (for example, 380nm-410nm) is selected, and sensitivities of the three masks 2 to the light in the selected band range are increased layer by layer from the surface of the solar cell precursor 1 in the direction away from the surface of the solar cell precursor 1; that is, the sensitivity of the mask 2 (bottommost) close to the surface of the solar cell precursor 1 to the light in the selected band range is lowest, the sensitivity of the mask 2 (uppermost) away from the surface of the solar cell precursor 1 to the light in the selected band range is highest, and the sensitivity of the mask 2 in the middle to the light in the selected band range is larger than the sensitivity of the adjacent lower mask 2 to the light in the selected band range but less than the sensitivity of the adjacent upper mask 2 to the light in the selected band range. The three masks are exposed simultaneously by the same light beam, the areas on the three masks 2 not required to be provided with the openings are exposed, and durations of exposure are the same; among all the multiple masks 2, the bottommost mask 2 has a lowest sensitivity to the light in the selected band range and absorbs least energy of the light, such that the bottommost mask 2 has a lowest curing degree and a smallest cured area (i.e., a volume of the smallest cured part of the mask 2); the uppermost mask 2 has a highest sensitivity to the light in the selected band range and absorbs most energy of the light, such that the uppermost mask 2 has a highest curing degree and a largest cured area (i.e., a largest volume of the cured part of the mask 2); the mask 2 in the middle has a sensitivity to the light in the selected band range larger than that of the adjacent lower mask 2 but smaller than that of the adjacent upper mask 2, such that the mask 2 in the middle has a curing degree and a cured area larger than that of the adjacent lower mask 2 and smaller than those of the adjacent upper mask 2; that is, the cured areas of the multiple masks 2 are increased layer by layer from the surface of the solar cell precursor 1 in the direction away from the surface of the solar cell precursor 1, exposure points on the same mask 2 are arranged at intervals, the cured areas formed by the adjacent exposure points arranged at intervals are not overlapped, an uncured area is formed between every two adjacent cured areas, and the uncured areas are decreased layer by layer from the surface of the solar cell precursor 1 in the direction away from the surface of the solar cell precursor 1; that is, the step-shaped development reaction area shown in FIG. 2-2 is formed.

In some embodiments, the development reaction area with width gradient is formed by using the following method: forming a single layer of mask 2 on a surface of the solar cell precursor 1 by coating; and exposing an area in the mask 2 not required to be provided with the opening, and adjusting a focal position and/or light intensity and/or wavelength of the exposure, such that absorption of exposure energy by the mask 2 is gradually increased from the surface of the solar cell precursor 1 in a direction away from the surface of the solar cell precursor 1, and then, a curing degree of the mask 2 is gradually increased from the surface of the solar cell precursor 1 in the direction away from the surface of the solar cell precursor 1, so as to form the development reaction area with width gradient in the mask 2; or exposing an area in the mask 2 required to be provided with the opening, and adjusting a focal position and/or light intensity and/or wavelength of the exposure, such that absorption of exposure energy by the mask 2 is gradually reduced from the surface of the solar cell precursor 1 in a direction away from the surface of the solar cell precursor 1, and then, a curing degree of the mask 2 is gradually reduced from the surface of the solar cell precursor 1 in the direction away from the surface of the solar cell precursor **1,** so as to form the development reaction area with width gradient in the mask 2. **In** the above embodiments, the single layer of mask 2 is adopted, and the single layer of mask 2 is easy to prepare, thus reducing the production cost of the mask 2.

Exemplarily, as shown in FIG. 3, a single layer of mask 2 is formed on the surface of the solar cell precursor 1 by coating; for convenience of description, the mask 2 is divided into three virtual layers including a first layer 21, a second layer 22 and a third layer 23 in sequence from the surface of the solar cell precursor 1 in the direction away from the surface of the solar cell precursor 1, the three layers of the mask 2 are exposed layer by layer from the surface of the solar cell precursor 1 in the direction away from the surface of the solar cell precursor 1, the area in the mask 2 required to be provided with the opening is exposed, exposure light intensities are decreased layer by layer from the surface of the solar cell precursor 1 in the direction away from the surface of the solar cell precursor 1, numbers of exposure times of the same exposure point are decreased layer by layer from the surface of the solar cell precursor 1 in the direction away from the surface of the solar cell precursor 1, and exposure wavelengths are increased layer by layer from the surface of the solar cell precursor 1 in the direction away from the surface of the solar cell precursor 1; the purpose is to allow the layer (bottommost layer) of the mask 2 close to the surface of the solar cell precursor 1 to absorb most light energy, the layer (uppermost layer) of the mask 2 away from the surface of the solar cell precursor 1 to absorb least light energy, and the middle layer of the mask 2 to absorb light energy less than that absorbed by the adjacent lower layer of the mask 2 but more than that absorbed by the adjacent upper layer of the mask 2; therefore, the bottommost layer of the mask 2 has a highest curing degree and a largest cured area (i.e., a volume of the largest cured part of the mask 2), the uppermost layer of the mask 2 has a lowest curing degree and a smallest cured area (i.e., a volume of the smallest cured part of the mask 2), the middle layer of the mask 2 has a curing degree and a cured area smaller than that of the adjacent lower layer of the mask 2 and larger than that of the adjacent upper layer of the mask 2; that is, the cured areas are decreased layer by layer from the surface of the solar cell precursor 1 in the direction away from the surface of the solar cell precursor 1, and finally, the step-shaped development reaction area shown in FIG. 3-4 is formed.

Exemplarily, as shown in FIG. 4, one mask 2 is formed on the surface of the solar cell precursor 1 by coating; for convenience of description, the mask 2 is divided into three virtual layers including a first layer 21, a second layer 22 and a third layer 23 in sequence from the surface of the solar cell precursor 1 in the direction away from the surface of the solar cell precursor 1, the three layers of the mask 2 are exposed layer by layer from the surface of the solar cell precursor 1 in the direction away from the surface of the solar cell precursor 1, the area in the mask 2 not required to be provided with opening is exposed, exposure light intensities are increased layer by layer from the surface of the solar cell precursor 1 in the direction away from the surface of the solar cell precursor 1, numbers of exposure times of the same exposure point are increased layer by layer from the surface of the solar cell precursor 1 in the direction away from the surface of the solar cell precursor 1, and exposure wavelengths are decreased layer by layer from the surface of the solar cell precursor 1 in the direction away from the surface of the solar cell precursor 1; the purpose is to allow the layer (bottommost layer) of the mask 2 close to the surface of the solar cell precursor 1 to absorb least light energy, the layer (uppermost layer) of the mask 2 away from the surface of the solar cell precursor 1 to absorb most light energy, and the middle layer of the mask 2 to absorb light energy more than that absorbed by the adjacent lower layer of the mask 2 but less than that absorbed by the adjacent upper layer of the mask 2; therefore, the bottommost layer of the mask 2 has a lowest curing degree and a smallest cured area (i.e., a smallest volume of the cured part of the mask 2), the uppermost layer of the mask 2 has a highest curing degree and a largest cured area (i.e., a largest volume of the cured part of the mask 2), the middle layer of the mask 2 has a curing degree and a cured area larger than that of the adjacent lower layer of the mask 2 and smaller than those of the adjacent upper layer of the mask 2; that is, the cured areas of the multiple layers of the mask 2 are increased layer by layer from the surface of the solar cell precursor 1 in the direction away from the surface of the solar cell precursor 1**,** exposure points on the same layer of the mask 2 are arranged at intervals, the cured areas formed by the adjacent exposure points arranged at intervals are not overlapped, an uncured area is formed between every two adjacent cured areas, and the uncured areas are decreased layer by layer from the surface of the solar cell precursor 1 in the direction away from the surface of the solar cell precursor 1, and finally, the step-shaped development reaction area shown in FIG. 4-4 is formed.

**In** some embodiments, a single layer of mask 2 is formed on the surface of the solar cell precursor 1 by coating, and a light transmission amount (or light transmission capacity) of the mask 2 is progressively decreased with a thickness of transmission of the light through the mask 2; an area in the mask 2 not required to be provided with opening is exposed to form the development reaction area with width gradient in the mask. Specifically, after the exposure light enters the mask 2, the mask 2 continuously absorbs and reflects the light, such that the light transmission amount of the mask 2 is progressively decreased with the thickness value of transmission of the light through the mask 2, and then, an exposure amount is increased layer by layer from the surface of the solar cell precursor 1 in the direction away from the surface of the solar cell precursor 1; that is, an exposed area (cured area) is increased layer by layer from the surface of the solar cell precursor 1 in the direction away from the surface of the solar cell precursor 1, and an unexposed area (uncured area) between every two exposed areas in the mask 2 forms the development reaction area with width gradient.

In some embodiments, as shown in FIG. 6 or FIG. 7, the preparation method for a grid line includes the following steps: dividing a surface of the solar cell precursor 1 into a first area and a second area; forming a first mask 2a on the first area, a number of the first masks 2a being one or more, and forming a second mask 2b on the second area, a number of the second masks 2b being one or more; exposing a local area of the first mask 2a according to properties (positive resist or negative resist) of the first mask 2a to form a first development reaction area with width gradient in the first mask 2a; developing the first mask 2a in the first development reaction area to form a first mask opening 31 with width gradient in the first development reaction area; and electroplating a first metal in the first mask opening 31 to form a first grid line 41 with width gradient. The preparation method further includes: exposing a local area of the second mask 2b according to properties of the second mask 2b to form a second development reaction area with width gradient in the second mask 2b; developing the second mask 2b in the second development reaction area to form a second mask opening 32 with width gradient in the second development reaction area; and electroplating a second metal in the second mask opening 32 to form a second grid line 42 with width gradient. The first metal and the second metal may be the same metal or different metals. The first area and the second area are both located on the same surface of the solar cell precursor 1, or the first area and the second area are located on two surfaces of the solar cell precursor 1 respectively, or the first area and the second area are arranged on each surface of the solar cell precursor 1.

If the number of the layer of the first masks 2a is single, for convenience of description, the first mask 2a is divided into three virtual layers including a first layer 2al of the first mask, a second layer 2a2 of the first-mask and a third layer 2a3 of the first mask in sequence from the surface of the solar cell precursor 1 in the direction away from the surface of the solar cell precursor 1, and referring to the foregoing embodiment, the first development reaction area with width gradient can be obtained by controlling the photosensibility and/or the absorption peak value of each layer of the first mask 2a or by controlling exposure parameters on each layer of the first mask 2a, such as the focal position of exposure, the number of exposure times of the same exposure point, the exposure light intensity or the wavelength. Similarly, the second mask 2b is divided into three virtual layers including a first layer 2bl of the second mask, a second layer 2b2 of the second mask and a third layer 2b3 of the second mask in sequence from the surface of the solar cell precursor 1 in the direction away from the surface of the solar cell precursor 1, and referring to the foregoing embodiment, the second development reaction area with width gradient can be obtained by controlling the photosensibility and/or the absorption peak value of each layer of the second mask 2b or by controlling exposure parameters on each layer of the second mask 2b, such as the focal position of exposure, the number of exposure times of the same exposure point, the exposure light intensity or the wavelength.

Certainly, if both the numbers of the layers of the first masks 2a and the second masks 2b are multiple, the development reaction area with width gradient may be formed by the technology applied to the single layer of mask 2.

Exemplarily, as shown in FIG. 6, the solar cell precursor 1 may be an IBC structure, both the first area and the second area are located on the same surface (for example, the front surface) of the solar cell precursor 1, the first mask 2a is formed on the first area, and the second mask 2b is formed on the second area; an opening area of the first mask 2a is exposed to form the first development reaction area with width gradient in the first mask 2a; the first mask 2a in the first development reaction area is developed to form the first mask opening 31 with width gradient in the first development reaction area; and the first metal is electroplated in the first mask opening 31 to form the first grid line 41 with width gradient. An opening area of the second mask 2b is exposed to form the second development reaction area with width gradient in the second mask 2b; the second mask 2b in the second development reaction area is developed to form the second mask opening 32 with width gradient in the second development reaction area; and the second metal is electroplated in the second mask opening 32 to form the second grid line 42 with width gradient. The first metal and the second metal may be the same metal or different metals. Preferably, the first metal and the second metal are both selected from silver, copper, aluminium, magnesium, chromium, nickel, molybdenum, tin, titanium, tungsten or an alloy or a laminate of any two or more of the above.

In a preferred embodiment, in order to improve the coating efficiency, forming the first mask 2a on the first area and forming the second mask 2b on the second area may be performed simultaneously, the first mask opening 31 and the electroplating of the first metal in the first mask opening 31 are then completed, and finally, the second mask opening 32 and the electroplating of the second metal in the second mask opening 32 are completed. If the first mask opening 31 and the second mask opening 32 are completed simultaneously, when the first metal is electroplated in the first mask opening 31, if the second mask opening 32 is not protected, the first metal is also electroplated in the second mask opening 32; when the first mask opening 31 and the electroplating of the first metal in the first mask opening 31 are completed firstly, and the second mask opening 32 and the electroplating of the second metal in the second mask opening 32 are then completed, during the electroplating of the first metal, the second mask opening 32 does not exist, and the first metal is not electroplated in the second mask opening 32. Further, when the second metal is electroplated in the second mask opening 32, a surface of the first metal (the first grid line 41) located in the first mask opening 31 may also be electroplated with the second metal; if the process requires the second metal to be electroplated on the surface of the first grid line 41, the second metal may be electroplated on the surface of the first grid line 41; that is, the first grid line 41 is a metal laminated structure, and the second grid line 42 is made of a single metal, for example, the first metal is copper, the second metal is tin, copper is prone to oxidization, and therefore, the tin may be continuously electroplated on a surface of the copper; if it is desired to avoid electroplating the second metal on the surface of the first grid line 41, the surface of the first grid line 41 may be coated with a protective layer, such as the mask 2, in advance before the second metal is electroplated.

In some embodiments, a side surface of the solar cell precursor 1 is coated with a mask material, the mask material is cured to form the mask 2, and when the metal is electroplated in the mask opening 3, the following problems can be avoided: the side surface of the solar cell precursor 1 is electroplated with the metal, such that the front surface and the back surface of the solar cell precursor 1 are conducted, thus influencing the efficiency of the photovoltaic cell.

In some embodiments, according to the property (positive resist or negative resist) of the mask 2, a local area of the mask 2 is exposed to form a development reaction area with a trapezoidal or step-shaped vertical section in the mask 2; the mask 2 in the development reaction area is developed to form a mask opening 3 with a trapezoidal or step-shaped vertical section in the development reaction area; and a metal is electroplated in the mask opening 3 to form the grid line 4 with a trapezoidal or step-shaped vertical section. The grid line 4 with width gradient includes a grid line 4 with a triangular or trapezoidal or step-shaped vertical section, and the grid line 4 with a trapezoidal or step-shaped vertical section is easy to directly form by electroplating, or the surface of the grid line 4 may be covered with a reflecting layer or an alloy welding layer with a melting point lower than 300°C or an organic protective layer , such that the grid line 4 has a triangular or trapezoidal vertical section; that is, the grid line 4 having a triangular or trapezoidal or step-shaped vertical section has a simple preparation process.

Preferably, the mask opening 3 has a trapezoidal vertical section, and the trapezoid has a base angle of 45-89 degrees, such that the grid line 4 with a trapezoidal vertical section can be obtained by performing electroplating in the mask opening 3; the base angle of the vertical section of the trapezoidal grid line 4 is 45-89 degrees, such that the reflection increasing effect of the grid line 4 is best while the electrical conductivity of the grid line 4 is balanced. For the grid line 4 with a trapezoidal vertical section, when a base and a height value of the trapezoid are fixed, the larger the base angle of the trapezoid is, the larger the area of the trapezoid (the area of the vertical section of the grid line 4) is, the larger the volume of the grid line 4 is, the better the electrical conductivity of the grid line 4 is, but the worse the reflection increasing effect of the grid line 4 is. Therefore, in order to balance the reflection increasing effect and the electrical conductivity of the grid line 4, the base angle of the vertical section of the trapezoidal grid line 4 is required to be controlled, and a preferred range is 45-89 degrees.

It should be noted that the triangular shape, when viewed as a whole, the trapezoidal shape, the step shape, or the like, mentioned in the present application means that the object forms an approximate triangular, trapezoidal or step shape, or the like, however sidelines of these shapes may not be straight lines when viewed in a micro scale, and angles of these shapes may not be intersections of straight lines. It will be appreciated that geometric products cannot be produced in industry and the description of the geometry of any industrial product is an approximate description.

In some embodiments, a dielectric layer is provided on the solar cell precursor 1, and after the mask opening 3 with width gradient is formed in the development reaction area, the dielectric layer right below the mask opening 3 may be removed by laser or chemical etching, such that the mask opening 3 is communicated with a conductive structure layer of the solar cell precursor 1, for example, a seed layer, a TCO layer, or a semiconductor doping layer, and then, the metal can be smoothly electroplated to the conductive structure layer to form the grid line 4.

In some embodiments, the grid line 4 with width gradient may have other shapes satisfying the definition of the width gradient besides the grid line 4 with a triangular or trapezoidal vertical section, and FIG. 5 exemplarily show schematic diagrams of the vertical sections of some grid lines 4 with width gradient.

In 5 examples shown in FIG. 5-1 to FIG. 5-5, the grid line 4 is divided into 4 layers sequentially distributed from top to bottom, including a 1st layer 4a, a 2nd layer 4b, a 3rd layer 4c, and a 4th layer 4d respectively, the 1st layer 4a is a top layer, the 4th layer 4d is a bottom layer, the 2nd layer 4b is wider than the 1st layer 4a, the 3rd layer 4c is wider than the 2nd layer 4b and the 1st layer 4a, the 4th layer 4d is wider than the 3rd layer 4c, the 2nd layer 4b, and the 1st layer 4a, and thus, in the 5 examples, the 2nd layer 4b, the 3rd layer 4c, and the 4th layer 4d are all width-expanded layers. The 5 examples differ mainly in the shape of each layer, as follows.

In the first example shown in FIG. 5-1, both lateral sides of the vertical section of each layer of the grid line 4 are straight lines extending vertically; that is, the vertical section of each layer in the up-down direction of the grid line 4 is rectangular or square, and the vertical section of the grid line 4 has a step shape as a whole.

In the second example shown in FIG. 5-2, both lateral sides of the vertical section of each layer of the grid line 4 are oblique lines obliquely extending in the up-down direction, and here, the oblique lines gradually tilt outwards from top to bottom, such that the vertical section of each layer is in a trapezoid shape with a narrow upper part and a wide lower part. In the embodiment, in any two adjacent layers in the up-down direction of all the layers of the grid line 4, the maximum width of the upper layer is smaller than the minimum width of the lower layer; for example, a width value of a lowermost part of the 1st layer 4a is smaller than that of an uppermost part of the 2nd layer 4b, a width value of a lowermost part of the 2nd layer 4b is smaller than that of an uppermost part of the 3rd layer 4c, and a width value of a lowermost part of the 3rd layer 4c is also smaller than that of an uppermost part of the 4th layer 4d.

In the third example shown in FIG. 5-3, two lateral sides of the vertical sections of several of all the layers of the grid line 4 are straight lines extending vertically, the vertical sections of these layers are rectangular or square, and specifically, here, these layers are the 1st layer 4a and the 3rd layer 4c; two lateral sides of the vertical sections of the other layers are oblique lines which gradually tilt outwards from top to bottom, the vertical sections of these layers are trapezoidal, and specifically, these layers are the 2nd layer 4b and the 4th layer 4d. A width value of the 1st layer 4a is less than a minimum width value of the 2nd layer 4b, a maximum width value of the 2nd layer 4b is less than a width value of the 3rd layer 4c, and the width value of the 3rd layer 4c is less than a minimum width value of the 4th layer 4d.

In the fourth example shown in FIG. 5-4, two lateral sides of the vertical section of each of all the layers of the grid line 4 are arcs extending in the up-down direction, and here, the arcs are arched inwards from top to bottom, such that the vertical section of each layer has an arc-side trapezoid shape. It should be noted that the arc-side trapezoid refers to a figure formed by replacing at least one of two lateral sides of the trapezoid with the arc.

In the fifth example shown in FIG. 5-5, two lateral sides of the vertical section of the 1st layer 4a of the grid line 4 are oblique lines gradually tilt outwards in the up-down direction, and the vertical section of the 1st layer 4a is trapezoidal; two lateral sides of the vertical section of the 2nd layer 4b are straight lines extending vertically, and the vertical section of the 2nd layer 4b is rectangular or square; two lateral sides of the vertical section of the 3rd layer 4c are arcs extending along the up-down direction, the arcs are specifically arched outwards from top to bottom, and the vertical section of the 3rd layer 4c is in an arc-side trapezoid shape; both lateral sides of the vertical section of the 4th layer 4d are oblique lines gradually tilt outwards in the up-down direction, and the vertical section of the 4th layer 4d is trapezoidal. A width value of a lowest part of the 1st layer 4a is smaller than that of the 2nd layer 4b, the width value of the 2nd layer 4b is smaller than that of an uppermost part of the 3rd layer 4c, and a width value of a lowest part of the 3rd layer 4c is smaller than that of an uppermost part of the 4th layer 4d.

The sixth example shown in FIG. 5-6 is mainly different from the 5 examples shown in FIG. 5-1 to FIG. 5-5 in that the 2nd layer 4b and the 4th layer 4d in this example are width-expanded layers. Specifically, the vertical sections of the 1st layer 4a, the 2nd layer 4b, the 3rd layer 4c and the 4th layer 4d are all trapezoidal, and two lateral sides of the vertical section of each layer are oblique lines which gradually tilt outwards along the up-down direction. The width of the 2nd layer 4b is greater than the width of the 1st layer 4a; the width of the 3rd layer 4c is less than the width of the 2nd layer 4b; the width of the 4th layer 4d is larger than the width of the 3rd layer 4c and larger than the widths of the 2nd layer 4b and the 1st layer 4a, the 2nd layer 4b is a width expanded layer relative to the 1st layer 4a, and the 4th layer 4d is the other width expanded layer relative to the 1st layer 4a, the 2nd layer 4b and the 3rd layer 4c.

In the 3 examples shown in FIG. 5-7 to FIG. 5-9, the vertical section of the grid line 4 is in an triangle shape with arc-sides, the width of the grid line 4 is gradually increased from top to bottom, and specifically, the vertical section includes a base L0, a lateral side L1, and a lateral side L2, and both the lateral side L1 and the lateral side L2 are arcs. In the seventh example shown in FIG. 5-7, both the lateral side L1 and the lateral side L2 are arcs arched inwards from top to bottom; in the eighth example shown in FIG. 5-8, both the lateral side L1 and the lateral side L2 are arcs arched outwards from top to bottom; in the ninth example shown in FIG. 5-9, one lateral side L1 is an arc arched outwards from top to bottom and the other lateral side L2 is an arc arched inwards from top to bottom.

In the 3 examples shown in FIG. 5-10 to FIG. 5-12, the vertical section of the grid line 4 is in an arc-side trapezoid shape, the width of the grid line 4 is gradually increased from top to bottom, and specifically, the vertical section includes a base L0, a top side L3, a lateral side L1, and a lateral side L2, and both the lateral side L1 and the lateral side L2 are arcs. In the tenth example shown in FIG. 5-10, both the lateral side L1 and the lateral side L2 are arcs arched inwards from top to bottom; in the eleventh example shown in FIG. 5-11, both the lateral side L1 and the lateral side L2 are arcs arched outwards from top to bottom; in the twelfth example shown in FIG. 5-12, one lateral side L1 is an arc arched outwards from top to bottom and the other lateral side L2 is an arc arched inwards from top to bottom.

Certainly, the shape of the vertical section of the grid line 4 with width gradient is not limited to the above examples. For the grid line 4 prepared by electroplating, the mask opening 3 serves as a mold of the grid line 4, the shape of the grid line 4 is determined by the shape of the mask opening 3, and therefore, the shape of the vertical section of the development reaction area is the same as the shape of the vertical section of the grid line 4, and the shape of the vertical section of the mask opening 3 is the same as the shape of the vertical section of the grid line 4; that is, for the shape of the vertical section of the development reaction area and the shape of the vertical section of the mask opening 3, reference may be made to the example in FIG. 5.

It should be noted that the vertical section of the grid line refers to a section where a plane perpendicular to the extending direction of the length of the grid line intersects with the grid line.

It should be noted that the photovoltaic module includes a photovoltaic cell and an encapsulation layer, and the photovoltaic cell includes at least one solar cell precursor 1 and a grid line 4 thereon.

In some embodiments, the number of the layers of the masks 2 is multiple, preferably 2 to 10, and more preferably 3 to 5. When the number of the masks is too small, the mask opening 3 with width gradient cannot be well prepared; when the number of the masks is too large, the preparation process and a device for realizing the process are complex, such that the preparation cost is increased, and the preparation efficiency is reduced. When the mask openings 3 of every two adjacent layers have a small width difference, all the mask openings 3 are mutually spliced along the up-down direction to form a trapezoidal or step-shaped vertical section, preferably an isosceles trapezoid-shaped vertical section, and the grid line 4 with a corresponding shape and width gradient can be formed after electroplating.

In the foregoing embodiments, by using photocrosslinking or photopolymerization or photodecomposition to produce the development reaction area with width gradient, the development reaction area with a smaller width can be obtained; the mask opening 3 with a smaller width can be obtained through development, the grid line 4 with a smaller line width can be obtained by electroplating the metal in the mask opening 3, and the line width w of the grid line 4 can be 5 microns≤w<50 microns, preferably 5 microns≤w≤20 microns or 20 microns≤w≤40 microns, and more preferably 5 microns≤w<10 microns. The screen printing is limited by the size of an opening of the screen and the performance of a printed material, such that the grid line 4 with a smaller line width cannot be obtained, and the line width w of the grid line 4 thereof is generally 50 microns≤w≤200 microns. The line width of the grid line 4 formed in the foregoing embodiment is smaller than the line width of the grid line 4 in the conventional art, such that the shading area of the grid line 4 is reduced, which is beneficial to improving the photoelectric conversion efficiency of the photovoltaic cell.

An embodiment of the present disclosure further provides a preparation method for a photovoltaic cell, wherein a grid line 4 on the solar cell precursor 1 is prepared by adopting the following steps:
S1 - coating a mask material over a front surface and/or back surface of the solar cell precursor 1, and curing the mask material to form a mask 2;
S2 - exposing a local area of the mask 2 according to properties of the mask 2, to form a development reaction area with width gradient in the mask 2;
S3 - developing the mask 2 in the development reaction area, to form a mask opening 3 with width gradient in the development reaction area;
S4 - electroplating a metal in the mask opening 3, to form the grid line 4 with width gradient; and
S5 - removing the mask 2.

A main improvement of the preparation method for a photovoltaic cell is the preparation method for a grid line, and therefore, the preparation method for a photovoltaic cell has the benefits of the preparation method for a grid line in the foregoing embodiment. In addition, all the improvements and technical solutions for the preparation method for a grid line in the foregoing embodiments may also be directly cited or indirectly applied to the preparation method for a photovoltaic cell. An embodiment of the present disclosure further provides a photovoltaic cell, including a solar cell precursor 1 and a grid line 4 with width gradient provided on the solar cell precursor 1, the grid line 4 with width gradient having a reflection increasing effect to increase the power generation efficiency of the photovoltaic cell.

In some embodiments, the grid line 4 with gradient width can be prepared according to the foregoing preparation method for a grid line.

**In** some embodiments, the grid line 4 has a triangular or trapezoidal or step-shaped vertical section.

**In** some embodiments, a surface of the grid line 4 is also covered with a reflecting layer made of bright tin or bright silver; or the surface of the grid line 4 is covered with an alloy welding layer with a melting point lower than 300°C, and the alloy welding layer is formed by tin and one or more of lead, bismuth, silver, copper, indium and zinc; or the surface of the grid line 4 is covered with an organic protective layer.

**In** some embodiments, at least the light receiving surface of the solar cell precursor is provided with the grid line 4, or both surfaces of the solar cell precursor are provided with the grid lines 4 respectively.

**In** some embodiments, there are a plurality of grid lines 4, the plurality of grid lines 4 on the same surface of the solar cell precursor are made of different metals, and/or the plurality of grid lines 4 on different surfaces of the solar cell precursor are made of different metals. The material of the grid line 4 may be selected from silver, copper, aluminium, magnesium, chromium, nickel, molybdenum, tin, titanium, tungsten or an alloy or a laminate of any two or more of the above.

For example, a plurality of grid lines 4 are arranged on the front surface or the back surface of the solar cell precursor, the front surface or the back surface of the solar cell precursor is divided into an area A and an area B, the grid lines 4 in the area A are made of a first metal, and the grid lines 4 in the area B are made of a second metal; preferably, the first metal is silver or copper and the second metal is aluminium.

For example, each of the front surface and the back surface of the solar cell precursor is provided with a plurality of grid lines 4, all the grid lines 4 on the front surface of the solar cell precursor are made of a first metal, and all the grid lines 4 on the back surface of the solar cell precursor are made of a second metal; the first metal is silver or copper and the second metal is aluminium.

For example, a plurality of grid lines 4 are arranged on each of the front surface and the back surface of the solar cell precursor, the front surface of the solar cell precursor is divided into an area A and an area B, the grid lines 4 in the area A are made of a first metal, and the grid lines 4 in the area B are made of a second metal; the grid lines 4 on the back surface of the solar cell precursor are all made of a first metal, a second metal or a third metal; preferably, the first metal is silver or copper, the second metal is aluminium, and the third metal is nickel.

For example, a plurality of grid lines 4 are arranged on each of the front surface and the back surface of the solar cell precursor, the front surface of the solar cell precursor is divided into an area A and an area B, the grid lines 4 in the area A are made of a first metal, and the grid lines 4 in the area B are made of a second metal; the back surface of the solar cell precursor is divided into an area C and an area D, the grid lines 4 in the area C are made of a first metal or a second metal, and the grid lines 4 in the area D are made of a third metal; preferably, the first metal is silver or copper, the second metal is aluminium, and the third metal is nickel.

For example, a plurality of grid lines 4 are arranged on each of the front surface and the back surface of the solar cell precursor, the front surface of the solar cell precursor is divided into an area A and an area B, the grid lines 4 in the area A are made of a first metal, and the grid lines 4 in the area B are made of a second metal; the back surface of the solar cell precursor is divided into an area C and an area D, the grid lines 4 in the area C are made of a third metal, and the grid lines 4 in the area D are made of a fourth metal; preferably, the first metal is a laminate formed by plating tin on copper, the second metal is aluminium, the third metal is nickel, and the fourth metal is tin.

In some embodiments, the minimum line width of the grid line is less than 50 microns and greater than or equal to 10 microns, and is smaller than the line width of the grid line 4 in the conventional art, such that the shading area of the grid line 4 is reduced, and the photoelectric conversion efficiency of the solar cell precursor 1 can be improved.

In some specific embodiments, three groups, T1, T2 and T35, of heterojunction double-sided cells at the size of 210 mm × 105 mm were selected for testing, each group includes 20 photovoltaic cells, single-side illumination was adopted for all the photovoltaic cells, the grid lines were made of copper, other parameters of the photovoltaic cells were kept the same except for the parameters listed in the table, and test results were shown in table 1.

**Table 1. test result of influence of line width of grid line on performance of photovoltaic cell**

| Serial number | Thin grid line width (µm) | Thin grid number | Total line width (µm) | Short-circuit current (A) | Efficiency (%) | Line width current (A/µm) | Line width efficiency (%/µm) |
|---|---|---|---|---|---|---|---|
| T1 | 40 | 54 | 2160 | 8.40 | 23.6 | 0.003889 | 0.010926 |
| T2 | 32 | 54 | 1728 | 8.50 | 23.8 | 0.004919 | 0.013773 |
| T3 | 20 | 66 | 1320 | 8.60 | 24.1 | 0.006515 | 0.018258 |

The short-circuit current and the efficiency are average values of 20 photovoltaic cells, the product of the thin grid line width and the thin grid number is called the total line width, the ratio of the short-circuit current to the total line width is called the line width current, and the ratio of the efficiency to the total line width is called the line width efficiency.

It can be seen from the data of T1 and T2 in table 1 that, under the condition that other parameters are the same, the thinner the grid line, the larger the short-circuit current, the higher the efficiency, the larger the line width current, and the higher the line width efficiency; that is, the thinner grid line can improve the efficiency of the photovoltaic cell. The thin grid line width and the thin grid number in T3 are different from those in T1 and T2, and in order to carry out comparison on the premise of a single variable, the term 'total line width' is introduced, and the total line width can reflect the shading area of the photovoltaic cell by all the grid lines; in the tests from T1 to T3, along with the gradual reduction of the total line width, the short-circuit current is gradually increased, the efficiency is gradually increased, the line width current is gradually increased, the line width efficiency is gradually increased, and it can also be concluded that the efficiency of the photovoltaic cell can be improved by the thinner grid line. Therefore, it is necessary to adopt an electroplating method to prepare thinner grid lines and a photovoltaic cell with the thinner grid lines.

**In** some specific embodiments, two groups, T4 and T5, of heterojunction double-sided cells at the size of 210 mm × 105 mm were selected for testing, each group includes 20 photovoltaic cells, single-side illumination was adopted for all the photovoltaic cells, the grid lines were made of copper, the grid lines were formed on all the solar cell precursors by electroplating using the electroplating method in the embodiment of the present application, other parameters of the photovoltaic cells were kept the same except for the parameters listed in the table, and test results were shown in table 2.

**Table 2. test result of influence of grid line with width gradient on performance of photovoltaic cell**

| Serial number | Thin grid line width (µm) | Thin grid number | Shape of vertical section of grid line | Power ratio of cell to module (%) | Current ratio of cell to module (%/µm) |
|---|---|---|---|---|---|
| T4 | 20 | 54 | Rectangular | 99.7 | 100.5 |
| T5 | 20 | 54 | Trapezoidal | 99.9 | 101.5 |

From the tests of T4 and T5, it can be seen that the power ratio of cell to module and the current ratio of cell to module of the trapezoidal grid line (grid line with width gradient) are higher than those of the rectangular grid line (grid line without width gradient); that is, the photovoltaic module obtained by encapsulating the photovoltaic cells with the grid lines with width gradient has a higher efficiency.

The above-mentioned embodiments are merely illustrative of the technical concepts and features of the present disclosure, and are intended to enable those skilled in the art to understand the contents of the present disclosure and implement the present disclosure, and not to limit the protective scope of the present disclosure, and all equivalent changes or modifications made according to the spirit of the present disclosure should be covered in the protective scope of the present disclosure.

## Claims

1. A preparation method for a grid line, comprising the following steps:
S1 - coating a mask material over a front surface and/or back surface of a solar cell precursor, and curing the mask material to form a mask;
S2 - exposing a local area of the mask according to properties of the mask, to form a development reaction area with width gradient in the mask;
S3 - developing the mask in the development reaction area, to form a mask opening with width gradient in the development reaction area;
S4 - electroplating a metal in the mask opening, to form the grid line with width gradient; and
S5 - removing the mask.

2. The preparation method for a grid line according to claim 1, further comprising:
step S6 - covering a surface of the grid line with a reflecting layer or an alloy welding layer with a melting point lower than 300°C or an organic protective layer;
wherein the step S6 is after the step S4 and before the step S5, or the step S6 is after the step S5.

3. The preparation method for a grid line according to claim 1, wherein the two surfaces of the solar cell precursor are coated with the mask material, and at least a light receiving surface of the solar cell precursor is provided with the grid line with width gradient; when the solar cell precursor has a double-sided power generation structure, the two surfaces of the solar cell precursor are provided with grid lines with width gradient.

4. The preparation method for a grid line according to claim 1, wherein the step S2 comprises:
exposing an area of the mask not required to be provided with the opening, such that a curing degree of the mask is gradually increased from the surface of the solar cell precursor in a direction away from the surface of the solar cell precursor, to form the development reaction area with width gradient in the mask; or exposing an area of the mask required to be provided with the opening, such that a curing degree of the mask is gradually reduced from the surface of the solar cell precursor in a direction away from the surface of the solar cell precursor, to form the development reaction area with width gradient in the mask;
the step S3 comprises:
according to the situation that the curing degree of the mask is gradually increased or gradually reduced from the surface of the solar cell precursor in the direction away from the surface of the solar cell precursor, selecting a corresponding developer for a development reaction with the mask in the development reaction area with width gradient, to form the mask opening with width gradient.

5. The preparation method for a grid line according to claim 1, comprising the following steps:
S11 - forming multiple layers of masks on the surface of the solar cell precursor by coating, the multiple layers of masks having different photosensibilities; and
S21 - exposing areas in the multiple layers of masks not required to be provided with openings, such that curing degrees of the multiple layers of masks are increased layer by layer from the surface of the solar cell precursor in a direction away from the surface of the solar cell precursor, to form the development reaction area with width gradient in the masks; or exposing areas in the multiple layers of masks required to be provided with openings, such that curing degrees of the multiple layers of masks are reduced layer by layer from the surface of the solar cell precursor in a direction away from the surface of the solar cell precursor, to form the development reaction area with width gradient in the masks;
wherein a concentration of a photosensitive component and/or a photosensitive ingredient is adjusted to form the multiple layers of masks having different photosensibilities;
or
S12 - forming multiple layers of masks on the surface of the solar cell precursor by coating, the multiple layers of masks having different absorption peak values; and
S22 - exposing areas in the multiple layers of masks not required to be provided with openings, such that curing degrees of the multiple layers of masks are increased layer by layer from the surface of the solar cell precursor in a direction away from the surface of the solar cell precursor, to form the development reaction area with width gradient in the masks; or exposing areas in the multiple layers of masks required to be provided with openings, such that curing degrees of the multiple layers of masks are reduced layer by layer from the surface of the solar cell precursor in a direction away from the surface of the solar cell precursor, to form the development reaction area with width gradient in the masks;
or
S13 - forming a single layer of mask on the surface of the solar cell precursor by coating; and
S23 - exposing an area in the mask not required to be provided with the opening, and adjusting a focal position and/or light intensity and/or wavelength of the exposure, such that absorption of exposure energy by the mask is gradually increased from the surface of the solar cell precursor in a direction away from the surface of the solar cell precursor, to form the development reaction area with width gradient in the mask; or exposing an area in the mask required to be provided with the opening, and adjusting a focal position and/or light intensity and/or wavelength of the exposure, such that absorption of exposure energy by the mask is gradually reduced from the surface of the solar cell precursor in a direction away from the surface of the solar cell precursor, to form the development reaction area with width gradient in the mask;
or
S14 - forming a single layer of mask on the surface of the solar cell precursor by coating, a light transmission amount of the mask being progressively decreased with a thickness of penetration of the light through the mask; and
S24 - exposing an area in the mask not required to be provided with the opening, to form the development reaction area with width gradient in the mask.

6. The preparation method for a grid line according to claim 1, comprising:
dividing the surface of the solar cell precursor into a first area and a second area;
preparing a first mask on the first area, and preparing a second mask on the second area;
exposing a local area of the first mask according to properties of the first mask, so as to form a first development reaction area with width gradient in the first mask;
developing the first mask in the first development reaction area, so as to form a first mask opening with width gradient in the first development reaction area;
electroplating a first metal in the first mask opening, so as to form a first grid line with width gradient;
exposing a local area of the second mask according to properties of the second mask, so as to form a second development reaction area with width gradient in the second mask;
developing the second mask in the second development reaction area, so as to form a second mask opening with width gradient in the second development reaction area; and
electroplating a second metal in the second mask opening, so as to form a second grid line with width gradient;
wherein the first metal and the second metal are the same metal or different metals.

7. The preparation method for a grid line according to claim 6, wherein the first area and the second area are both located on the same surface of the solar cell precursor, or the first area and the second area are located on two surfaces of the solar cell precursor respectively.

8. The preparation method for a grid line according to claim 1, wherein a side surface of a solar cell precursor is coated with mask material, such that the mask material is cured to form a mask.

9. The preparation method for a grid line according to claim 1, wherein the local area of the mask is exposed according to properties of the mask, so as to form the development reaction area with a trapezoidal or step-shaped vertical section in the mask;
the mask in the development reaction area is developed, so as to form a mask opening with a trapezoidal or step-shaped vertical section in the development reaction area; and
a metal is electroplated in the mask opening, so as to form the grid line with a trapezoidal or step-shaped vertical section.

10. The preparation method for a grid line according to claim 9, wherein the mask opening has a trapezoidal vertical section, and the trapezoid has a base angle of 45-89 degrees.

11. The preparation method for a grid line according to claim 1, wherein if the metal is electroplated in the mask opening that a grid line with a triangular or trapezoidal vertical section is not formed, a surface of the grid line is covered with a reflecting layer or an alloy welding layer with a melting point lower than 300°C or an organic protective layer, such that the vertical section of the grid line is triangular or trapezoidal.

12. A preparation method for a photovoltaic cell, wherein a grid line on a solar cell precursor is prepared by the following steps:
S1 - coating a mask material over a front surface and/or back surface of the solar cell precursor, and curing the mask material to form a mask;
S2 - exposing a local area of the mask according to properties of the mask, to form a development reaction area with width gradient in the mask;
S3 - developing the mask in the development reaction area, to form a mask opening with width gradient in the development reaction area;
S4 - electroplating a metal in the mask opening, to form the grid line with width gradient; and
S5 - removing the mask.

13. A photovoltaic cell, comprising a solar cell precursor and a grid line with width gradient provided on the solar cell precursor.

14. The photovoltaic cell according to claim 13, wherein the grid line has a triangular or trapezoidal or step-shaped vertical section.

15. The photovoltaic cell according to claim 13, wherein a surface of the grid line is further covered with a bright tin or bright silver reflecting layer; or
a surface of the grid line is covered with an alloy welding layer with a melting point lower than 300°C, and the alloy welding layer is formed by tin and one or more of lead, bismuth, silver, copper, indium and zinc; or
a surface of the grid line is covered with an organic protective layer.

16. The photovoltaic cell according to claim 13, wherein at least a light receiving surface of the solar cell precursor is provided with the grid line, or both surfaces of the solar cell precursor are provided with grid lines.

17. The photovoltaic cell according to claim 13, wherein a plurality of grid lines on a same surface of the solar cell precursor are made of different metals, and/or a plurality of grid lines on different surfaces of the solar cell precursor are made of different metals.

18. The photovoltaic cell according to any one of claims 13 to 17, wherein a minimum line width of the grid line is less than 50 microns and greater than or equal to 5 microns.
